# EUROPEAN PATENT APPLICATION

(11) **EP 4 637 293 A1**
(43) Date of publication of application: **22.10.2025**
(21) Application number: 25158261.5
(22) Date of filing: 17.02.2025
(51) Int. Cl.: H10B 43/27, H10B 43/50

(54) **SEMICONDUCTOR DEVICES AND DATA STORAGE SYSTEMS INCLUDING THE SAME**

(30) Priority: 15.04.2024 KR 20240049852
(71) Applicant: Samsung Electronics Co., Ltd., Suwon-si, Gyeonggi-do 16677 (KR)
(72) Inventor: BAEK, Seokcheon, 16677 Suwon-si (KR); BAIK, Min, 16677 Suwon-si (KR); LEE, Myeongjun, 16677 Suwon-si (KR); LEE, Jiho, 16677 Suwon-si (KR)
(74) Representative: Marks & Clerk LLP

(57) **Abstract**

A semiconductor device may include a source structure, gate electrodes on the source structure, spaced apart from each other in a first direction perpendicular to an upper surface of the source structure, extending by different lengths in a second direction perpendicular to the first direction, and defining a stepped structure, and a pad insulating region on a portion of the source structure and being outside of the gate electrodes in the second direction, wherein the source structure has a bent upper surface covering a side surface in the second direction and a lower surface of the pad insulating region.

## Description

### BACKGROUND

The present disclosure relates to semiconductor devices and data storage systems including the same.

In a data storage system requiring data storage, a semiconductor device capable of storing high-capacity data is required. Accordingly, ways in which to increase the data storage capacity of semiconductor devices have been researched. For example, as one of the methods of increasing the data storage capacitance of a semiconductor device, a semiconductor device including memory cells arranged three-dimensionally instead of memory cells arranged two-dimensionally has been proposed.

### SUMMARY

Some example embodiments of the present disclosure provide semiconductor devices having improved reliability.

Some example embodiments of the present disclosure provide data storage systems including a semiconductor device having improved reliability.

According to an example embodiment of the present disclosure, a semiconductor device according to may include a first semiconductor structure including a substrate, circuit elements on the substrate, and circuit interconnection lines on the circuit elements, and a second semiconductor structure on the first semiconductor structure, and the second semiconductor structure may include a plate layer, gate electrodes on the plate layer, the gate electrodes spaced apart from each other in a first direction perpendicular to an upper surface of the plate layer, the gate electrodes extending by different lengths in a second direction perpendicular to the first direction, the gate electrodes each including a gate pad region, an upper surface of the gate pad region of a corresponding one of the gate electrodes being exposed upwardly from other ones of the gate electrodes, interlayer insulating layers alternately stacked with the gate electrodes, a horizontal insulating layer on a portion of the plate layer and below the interlayer insulating layers, a horizontal conductive layer on the horizontal insulating layer and below the interlayer insulating layers, the horizontal conductive layer being bent and extended so that a level of an upper surface thereof is lowered from a first level to a second level, a pad insulating layer on the horizontal conductive layer in a region in which the upper surface of the horizontal conductive layer is at the second level, channel structures penetrating through at least a portion of the gate electrodes and extending in the first direction, and contact plugs each connected to the gate pad region of a corresponding one of the gate electrodes and extending in the first direction.

According to an example embodiment of the present disclosure, a semiconductor device may include a source structure, gate electrodes on the source structure, the gate electrodes spaced apart from each other in a first direction perpendicular to an upper surface of the source structure, the gate electrodes extending by different lengths in a second direction perpendicular to the first direction, to define a stepped structure, and a pad insulating region on a portion of the source structure, the pad insulating region being outside of the gate electrodes in the second direction, and the source structure may have a bent upper surface covering a side surface in the second direction and a lower surface of the pad insulating region.

According to an example embodiment of the present disclosure, a data storage system may include a semiconductor storage device including a first semiconductor structure including circuit elements, a second semiconductor structure on a surface of the first semiconductor structure, and an input/output pad electrically connected to the circuit elements, and a controller electrically connected to the semiconductor storage device through the input/output pad and configured to control the semiconductor storage device, wherein the second semiconductor structure may include a plate layer, a horizontal insulating layer on the plate layer, a horizontal conductive layer on the horizontal insulating layer and including a first region in which an upper surface thereof is at a first level and a second region in which the upper surface thereof is at a second level, the second level being lower than the first level, gate electrodes spaced apart from each other on the horizontal conductive layer in a first direction, perpendicular to the upper surface of the horizontal conductive layer, the gate electrodes extending by different lengths in a second direction perpendicular to the first direction, to define a stepped structure, and a pad insulating region on the second region of the horizontal conductive layer, the pad insulating region being adjacent to an end of the stepped structure.

The following features may apply to any of the relevant above described example embodiments.

The circuit interconnection lines may be arranged to provide an electrical connection between the circuit elements and the gate electrodes.

The first semiconductor structure may be referred to a first structure and the second semiconductor structure may be referred to as a second structure.

The channel structures include a semiconductor material.

The plate layer may be a layer formed of a semiconductor material. The plate layer and the horizontal conductive layer may together form a common source line for the semiconductor device.

In some embodiments, at least some of the gate electrodes extend by different amounts in the second direction. For example, the gate electrodes may comprise a plurality of groups of gate electrodes, each group of gate electrodes comprising one or more gate electrodes. The length of the gate electrodes is different between different ones of the groups of gate electrodes.

The horizontal conductive layer may cover a top surface of the horizontal insulating layer. Part of the horizontal conductive layer may be on a top surface of the plate layer, rather than the top surface of the horizontal insulating layer.

Semiconductor devices having improved reliability and data storage systems including the same may be provided by including a pad insulating layer disposed on the plate layer, outside of a stepped structure of the gate electrodes.

Advantages and effects of the present application are not limited to the foregoing content and may be more easily understood in the process of describing a specific example embodiment of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of a semiconductor device according to an example embodiment;
FIGS. 2A to 2D are schematic cross-sectional views of a semiconductor device according to an example embodiment;
FIGS. 3A to 3C are schematic partially enlarged views illustrating regions of a semiconductor device according to an example embodiment;
FIGS. 4A and 4B are schematic partially enlarged views of a semiconductor device according to some example embodiments;
FIGS. 5A and 5B are a schematic plan view and a cross-sectional view of a semiconductor device according to an example embodiment, respectively;
FIGS. 6A and 6B are schematic cross-sectional views of a semiconductor device according to an example embodiment;
FIG. 7 is a schematic cross-sectional view of a semiconductor device according to an example embodiment;
FIGS. 8A to 8C are schematic cross-sectional views and partially enlarged views of a semiconductor device according to an example embodiment;
FIGS. 9A and 9B are a schematic cross-sectional view and a partially enlarged view of a semiconductor device according to an example embodiment;
FIG. 10 is a schematic cross-sectional view of a semiconductor device according to an example embodiment;
FIG. 11 is a schematic cross-sectional view of a semiconductor device according to an example embodiment;
FIGS. 12 to 23 are schematic cross-sectional views illustrating a method of manufacturing a semiconductor device according to an example embodiment;
FIGS. 24A and 24B are schematic cross-sectional views illustrating a method of manufacturing a semiconductor device according to an example embodiment;
FIGS. 25A and 25B are schematic cross-sectional views illustrating a method of manufacturing a semiconductor device according to an example embodiment;
FIG. 26 is a view schematically illustrating a data storage system including a semiconductor device according to an example embodiment;
FIG. 27 is a perspective view schematically illustrating a data storage system including a semiconductor device according to an example embodiment; and
FIG. 28 is a cross-sectional view schematically illustrating a semiconductor package according to an example embodiment.

### DETAILED DESCRIPTION

Hereinafter, some example embodiments of the present disclosure will be described with reference to the accompanying drawings.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

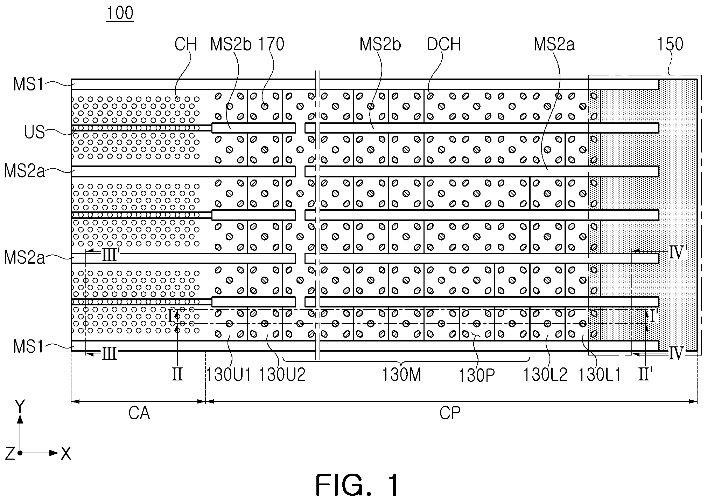

FIG. 1 is a schematic plan view of a semiconductor device according to example embodiments.

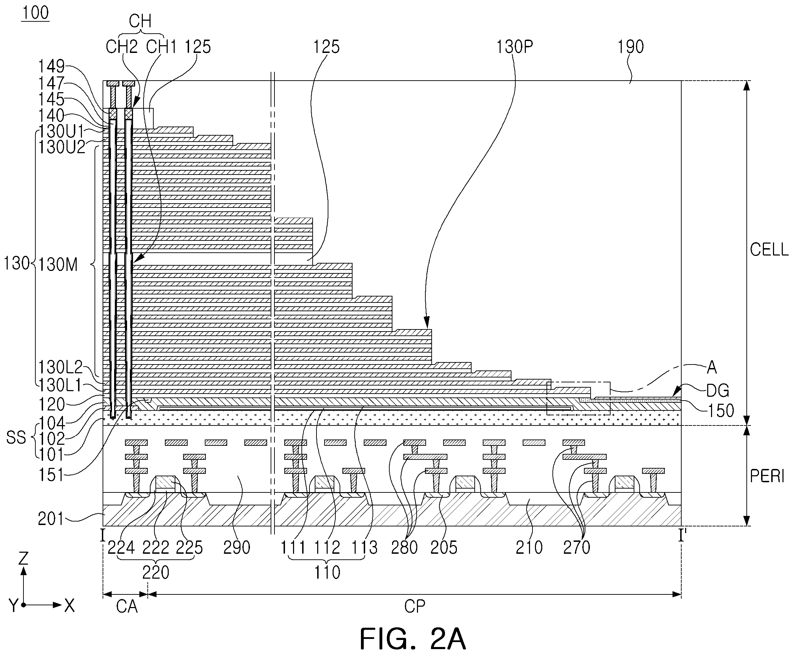

FIGS. 2A to 2D are schematic cross-sectional views of a semiconductor device according to an example embodiment. FIGS. 2A to 2D are cross-sections taken along cutting lines I-I', II-II', III-III', and IV-IV' of FIG. 1, respectively.

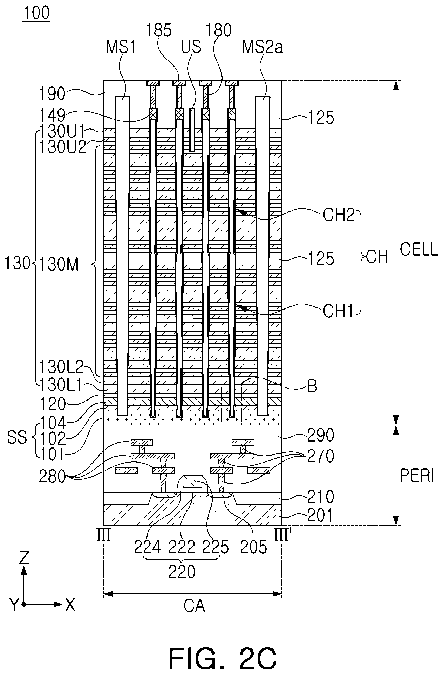

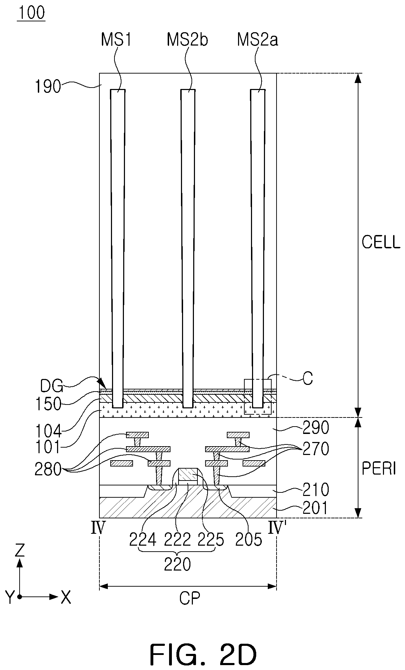

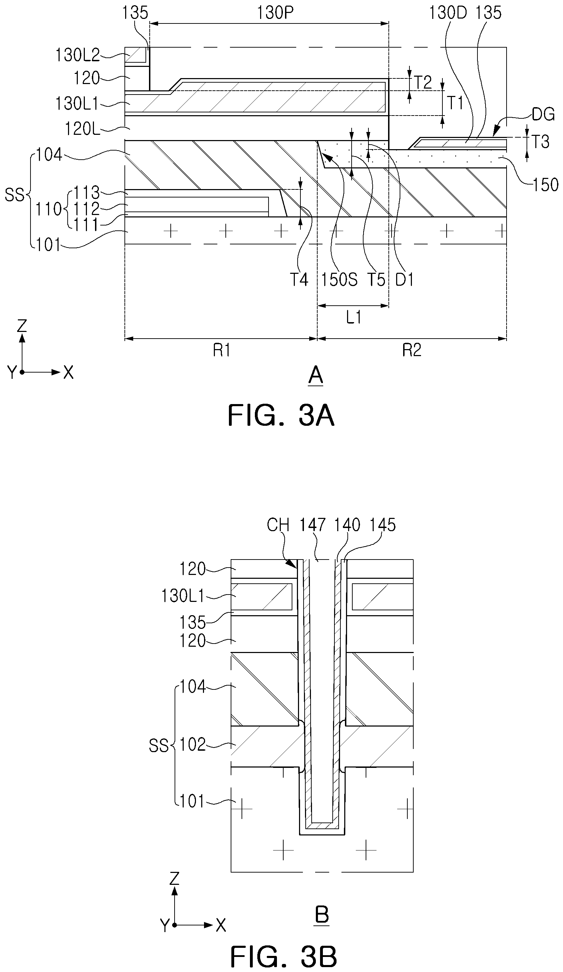

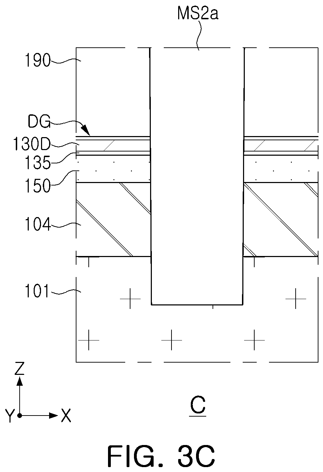

FIGS. 3A to 3C are schematic partially enlarged views illustrating regions of a semiconductor device according to an example embodiment. FIG. 3A is an enlarged view of region 'A' of FIG. 2A, FIG. 3B is an enlarged view of region 'B' of FIG. 2C, and FIG. 3C is an enlarged view of region 'C' of FIG. 2D.

Referring to FIGS. 1 to 3B, a semiconductor device 100 may include a peripheral circuit region PERI, which includes a first semiconductor structure including a substrate 201, and a memory cell region CELL, which includes a second semiconductor structure including a plate layer 101. The memory cell region CELL may be disposed on the peripheral circuit region PERI. In some example embodiments, however, the memory cell region CELL may be disposed below the peripheral circuit region PERI.

The peripheral circuit region PERI may include a substrate 201, impurity regions 205 and device isolating layers 210 within the substrate 201, circuit elements 220 disposed on the substrate 201, a peripheral region insulating layer 290, circuit contact plugs 270, and circuit interconnection lines 280.

The substrate 201 may have an upper surface extending in an X-direction and a Y-direction. An active region may be defined on the substrate 201 by the device isolating layers 210. The impurity regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each of the circuit elements 220 may include a circuit gate dielectric layer 222, a spacer layer 224, and a circuit gate electrode 225. The impurity regions 205 may be disposed as source/drain regions in the substrate 201 on both sides of the circuit gate electrode 225.

The peripheral region insulating layer 290 may be disposed on the circuit element 220 on the substrate 201. The peripheral region insulating layer 290 may include a plurality of insulating layers formed in different process operations. The peripheral region insulating layer 290 may be formed of an insulating material.

The circuit contact plugs 270 and the circuit interconnection lines 280 may be included in a circuit interconnection structure electrically connected to the circuit elements 220 and the impurity regions 205. The circuit contact plugs 270 may have a cylindrical shape, and the circuit interconnection lines 280 may have a line shape. An electrical signal may be applied to the circuit element 220 through the circuit contact plugs 270 and the circuit interconnection lines 280. In regions not illustrated, the circuit contact plugs 270 may also be connected to the circuit gate electrode 225. The circuit interconnection lines 280 may be connected to the circuit contact plugs 270 and may be arranged in a plurality of layers. The circuit contact plugs 270 and the circuit interconnection lines 280 may include a conductive material, and may include for example, tungsten (W), copper (Cu), and/or aluminum (Al), and each of the components may further include a diffusion barrier. In example embodiments, the number of layers of circuit contact plugs 270 and circuit interconnection lines 280 may be variously changed.

The memory cell region CELL may have a cell array region CA and a cell pad region CP, and may include a source structure SS, gate electrodes 130 stacked on the source structure SS and extending to different lengths in the cell pad region CP, interlayer insulating layers 120 alternately stacked with the gate electrodes 130, channel structures CH penetrating through a stack structure of the gate electrodes 130 in the cell array region CA, first and second separation regions MS1, MS2a and MS2b extending by penetrating through the gate electrodes 130, upper separation regions US penetrating through some gate electrodes 130 disposed in an upper portion, among the gate electrodes 130, contact plugs 170 connected to the gate electrodes 130 in the cell pad region CP and extending vertically, a pad insulating layer 150 disposed on the source structure SS outside the gate electrodes 130, and a dummy structure DG on the pad insulating layer 150.

The memory cell region CELL may include substrate insulating layers 121 penetrating through the source structure SS, support structures DCH disposed to penetrate through the stack structure of the gate electrodes 130 in the cell pad region CP, contact insulating layers 160 around contact plugs 170, studs 180 on the channel structures CH and the contact plugs 170, cell interconnection lines 185 on the studs 180, and cell region insulating layer 190 covering the gate electrodes 130.

In the memory cell region CELL, the cell array region CA is a region in which the gate electrodes 130 are vertically stacked and the channel structures CH are arranged, and may be a region in which memory cells are disposed. The cell pad region CP is a region in which the gate electrodes 130 extend to different lengths, and may correspond to a region for electrically connecting the memory cells to the peripheral circuit region PERI. The cell pad region CP may be disposed in at least one end of the cell array region CA in at least one direction, for example, the X-direction.

The source structure SS may include a plate layer 101, a first horizontal conductive layer 102, and a second horizontal conductive layer 104, which are sequentially stacked in the cell array region CA, and may further include a horizontal insulating layer 110 disposed between the plate layer 101 and the second horizontal conductive layer 104 in the cell pad region CP. The source structure SS may have an upper surface bent to lower a level in the cell pad region CP.

The plate layer 101 has the shape of a plate and may function as at least a portion of the common source line of the semiconductor device 100. The plate layer 101 may have an upper surface extending in the X-direction and the Y-direction. The plate layer 101 may include a conductive material. For example, the plate layer 101 may include a semiconductor material, such as a group IV semiconductor, a group III-V compound semiconductor, or a group II-VI compound semiconductor. For example, the Group IV semiconductors may include silicon, germanium, or silicon-germanium. The plate layer 101 may further include impurities. The plate layer 101 may be provided as a polycrystalline semiconductor layer such as a polycrystalline silicon layer or an epitaxial layer.

The first and second horizontal conductive layers 102 and 104 may be sequentially stacked and disposed on an upper surface of the plate layer 101 in the cell array region CA. The first horizontal conductive layer 102 may not extend into the cell pad region CP, and the second horizontal conductive layer 104 may extend into the cell pad region CP. The first horizontal conductive layer 102 may function as a portion of a common source line of the semiconductor device 100, and may function as, for example, the common source line with plate layer 101. As illustrated in FIG. 3B, the first horizontal conductive layer 102 may be directly connected to the channel layer 140 around the channel layer 140.

The second horizontal conductive layer 104 may be in contact with the plate layer 101 in some regions of the cell pad region CP in which the first horizontal conductive layer 102 and the horizontal insulating layer 110 are not disposed. In the regions, the second horizontal conductive layer 104 may be bent along ends of the first horizontal conductive layer 102 and/or the horizontal insulating layer 110, and a planarizing insulating layer 151 including an insulating material may be disposed on some of the bent portions of the second horizontal conductive layer 104 to fill the bent portions. The first and second horizontal conductive layers 102 and 104 may include a semiconductor material, and may include, for example, polycrystalline silicon.

The horizontal insulating layer 110 may be disposed on the plate layer 101 on the same level as the first horizontal conductive layer 102 in at least a portion of the cell pad region CP. For example, the horizontal insulating layer 110 may be disposed between the plate layer 101 and the second horizontal conductive layer 104, in a region of the cell pad region CP in which the pad insulating layer 150 and the first and second separation regions MS1, MS2a and MS2b are not disposed. One end of the horizontal insulating layer 110 may be disposed adjacently to a boundary between the cell array region CA and the cell pad region CP, and the other end thereof may be disposed between an end of a first lower gate electrode 130L1 and an end of a second lower gate electrode 130L2 in plan view. The horizontal insulating layer 110 may include first to third horizontal insulating layers 111, 112 and 113 sequentially stacked on the plate layer 101. The horizontal insulating layer 110 may be layers remaining after a portion of the horizontal insulating layer 110 is replaced with the first horizontal conductive layer 102 during a manufacturing process of the semiconductor device 100. The horizontal insulating layer 110 may include silicon oxide, silicon nitride, silicon carbide, or silicon oxynitride. The first and third horizontal insulating layers 111 and 113 and the second horizontal insulating layer 112 may include different insulating materials. For example, the first and third horizontal insulating layers 111 and 113 may be formed of the same material as a material of the interlayer insulating layers 120, and the second horizontal insulating layer 112 may be formed of a material different from a material of the interlayer insulating layers 120.

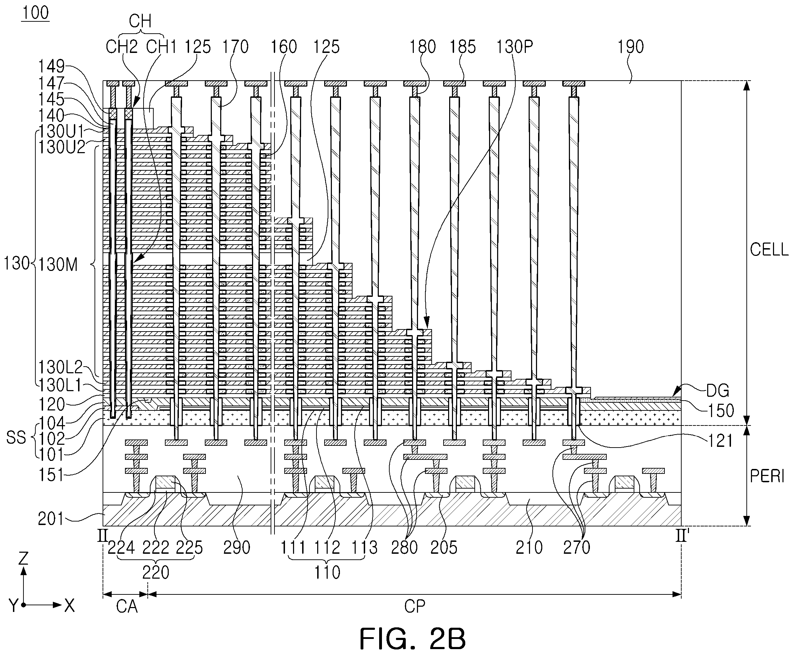

As illustrated in FIG. 2B, the substrate insulating layers 121 may be disposed to penetrate through the plate layer 101, the horizontal insulating layer 110, and the second horizontal conductive layer 104, in a portion of the cell pad region CP. The substrate insulating layers 121 may be further disposed in the cell array region CA, and may be disposed, for example, in a region in which a through-via extending from the memory cell area CELL to the peripheral circuit region PERI is disposed. An upper surface of the substrate insulating layer 121 may be coplanar with an upper surface of the second horizontal conductive layer 104, but example embodiments of the present disclosure are not limited thereto. The substrate insulating layer 121 may include an insulating material, for example, silicon oxide, silicon nitride, silicon carbide, or silicon oxynitride.

The gate electrodes 130 may be stacked on the plate layer 101 and vertically spaced apart from each other, and may thus be included in a stack structure, together with the interlayer insulating layers 120. The stack structure may include vertically stacked upper and lower stack structures. However, according to some example embodiments, the stack structure may be formed of a single stack structure.

The gate electrodes 130 may include first and second lower gate electrodes 130L1 and 130L2 included in gates of ground select transistors, memory gate electrodes 130M included in a plurality of memory cells, and first and second upper gate electrodes 130U1 and 130U2 included in gates of string select transistors. The number of memory gate electrodes 130M included in the memory cells may be determined according to the capacity of the semiconductor device 100. According to an example embodiment, there may be one to four or more upper and lower gate electrodes 130L1, 130L2, 130U1 and 130U2, respectively, and each of the upper and lower gate electrodes 130L1, 130L2, 130U1 and 130U2 may have a structure identical to or different from a structure of the memory gate electrodes 130M. In some example embodiments, at least one of the upper and lower gate electrodes 130L1, 130L2, 130U1 and 130U2 may be a gate electrode included in an erase transistor used in an erase operation using a gate induced leakage current (GIDL) phenomenon. Additionally, some of the gate electrodes 130, for example, the memory gate electrodes 130M adjacent to the upper and lower gate electrodes 130L1, 130L2, 130U1 and 130U2 may be dummy gate electrodes.

As illustrated in FIG. 1, the gate electrodes 130 may be separated from each other in the Y-direction by the first separation regions MS1 continuously extending from the cell array region CA to the cell pad region CP. The gate electrodes 130 between a pair of first separation regions MS1 may be included in one memory block, but the range of the memory block is not limited thereto. Some of the gate electrodes 130, for example, the memory gate electrodes 130M may form a single layer within one memory block, respectively.

The gate electrodes 130 may be stacked on the cell array region CA and the cell pad region CP and vertically spaced apart from each other, and may extend to different lengths in the cell pad region CP to define a stepped structure. The gate electrodes 130 may have a stepped structure in the Y-direction. Due to the stepped structure, the gate electrodes 130 may be configured so that a lower gate electrode 130 thereof may extend to be longer than an upper gate electrode 130 thereof, and may have regions in which upper surfaces thereof are exposed upwardly from the interlayer insulating layers 120 and other gate electrodes 130, respectively, and the regions may be referred to as gate pad regions 130P. In each of the gate electrodes 130, the gate pad region 130P may be a region including an end of the gate electrode 130 along the X-direction.

The gate electrodes 130 may be connected to the contact plugs 170 in the gate pad regions 130P, respectively. The gate electrodes 130 may have an increased thickness in the gate pad regions 130P. As illustrated in FIG. 3A, the gate electrode 130 may extend from the cell array region CA to a first thickness T1, and may be increased in thickness by a second thickness T2 in the gate pad region 130P.

The gate electrodes 130 may include conductive layers and gate dielectric layers 135 covering upper surfaces, lower surfaces, and side surfaces of the conductive layers. The conductive layers may include a metallic material, such as tungsten (W). According to an example embodiment, the conductive layers may include polycrystalline silicon or metal silicide material. In some example embodiments, the conductive layers may further include a diffusion barrier, and for example, the diffusion barrier may include tungsten nitride (WN), tantalum nitride (TaN), titanium nitride (TiN), or combinations thereof.

The gate dielectric layers 135 may be in contact with the channel dielectric layers 145 of the channel structures CH. For example, the gate dielectric layers 135 may be layers blocking a carrier during an operation of the semiconductor device 100, together with the channel dielectric layers 145 of the channel structures CH. The gate dielectric layers 135 may include a dielectric material, for example, aluminum oxide (AlO). When the gate electrodes 130 include the diffusion barrier, the diffusion barrier may be disposed between the conductive layers and the gate dielectric layers 135.

The interlayer insulating layers 120 may be disposed below corresponding ones of the gate electrodes 130, respectively, and may thus be included in a stack structure with the gate electrodes 130. Like the gate electrodes 130, the interlayer insulating layers 120 may be spaced apart from each other in a direction, perpendicular to the upper surface of the plate layer 101 and extend in the X-direction. In the stack structure, relatively thick upper interlayer insulating layers 125 may be disposed on uppermost portions of the upper and lower stack structures. However, the thickness and shape of the interlayer insulating layers 120 and the upper interlayer insulating layer 125 may be variously changed in example embodiments. The interlayer insulating layers 120 and the upper interlayer insulating layer 125 may include an insulating material such as silicon oxide or silicon nitride.

The pad insulating layer 150 may be disposed on an upper surface of the second horizontal conductive layer 104 at least outside of the gate electrodes 130. The pad insulating layer 150 may be disposed between the dummy structure DG and the second horizontal conductive layer 104. As illustrated in FIGS. 1 and 2A, the pad insulating layer 150 may have an end overlapping a gate pad region 130P of a first lower gate electrode 130L1 in a lowermost portion, among the gate electrodes 130, in the Z-direction, and may extend outward of the gate electrodes 130 in the X-direction. The pad insulating layer 150 may be disposed on a region in which the second horizontal conductive layer 104 is bent and lowered along an end of the horizontal insulating layer 110.

As illustrated in FIG. 3A, the second horizontal conductive layer 104 may include a first region R1 in which an upper surface thereof is disposed on a first level, and a second region R2 in which an upper surface thereof is disposed on a second level, lower than the first level. The pad insulating layer 150 may be disposed on the second region R2 of the second horizontal conductive layer 104. An upper surface of the pad insulating layer 150 may be coplanar with an upper surface of the second horizontal conductive layer 104 below a lowermost interlayer insulating layer 120L and may be disposed on the first level. The upper surface of the pad insulating layer 150 may be disposed on a level lower than a lower surface of the lowermost interlayer insulating layer 120L, outside the interlayer insulating layers 120 and the gate electrodes 130. Outside the interlayer insulating layers 120 and the gate electrodes 130, the upper surface of the pad insulating layer 150 may be disposed on a third level which is lower than the first level by a first depth D1. For example, the first depth D1 may range from about 100 Å to about 300 Å. A maximum thickness T5 of the pad insulating layer 150 may be identical to or similar to a thickness T4 of the horizontal insulating layer 110.

One side surface 150S and a lower surface of the pad insulating layer 150 may be in contact with the second horizontal conductive layer 104. The side surface 150S of the pad insulating layer 150 may be disposed below the gate pad region 130P of the first lower gate electrode 130L1 in the lowermost portion. A length L1 in which the pad insulating layer 150 and the first lower gate electrode 130L1 overlap each other in the Z-direction may be variously changed in example embodiments. For example, the location of the side surface 150S of the pad insulation layer 150 may be variously changed in a range of a portion disposed between an outermost channel structure CH and an end of the first lower gate electrode 130L1. In FIG. 3A, the side surface 150S of the pad insulating layer 150 is illustrated as being inclined, but the specific shape of the side surface 150S of the pad insulating layer 150 is not limited thereto.

The pad insulating layer 150 may include an insulating material, for example, silicon oxide or silicon oxynitride. The pad insulating layer 150 may also be referred to as a pad insulating region.

The dummy structure DG may be disposed on the pad insulating layer 150. The dummy structure DG may have a shape corresponding to an increased thickness region of the gate pad regions 130P of the gate electrodes 130. A thickness T3 of the dummy structure DG may be identical to or similar to the second thickness T2. The dummy structure DG may have a structure corresponding to the gate electrodes 130. As illustrated in FIGS. 3A and 3C, the dummy structure DG may include a dummy gate electrode layer 130D, and the dummy gate electrode layer 130D may include a conductive layer and a gate dielectric layer 135 covering an upper surface, a lower surface, and at least one side surface of the conductive layer. When the gate electrodes 130 include the diffusion barrier, the dummy gate electrode layer 130D may also include the diffusion barrier.

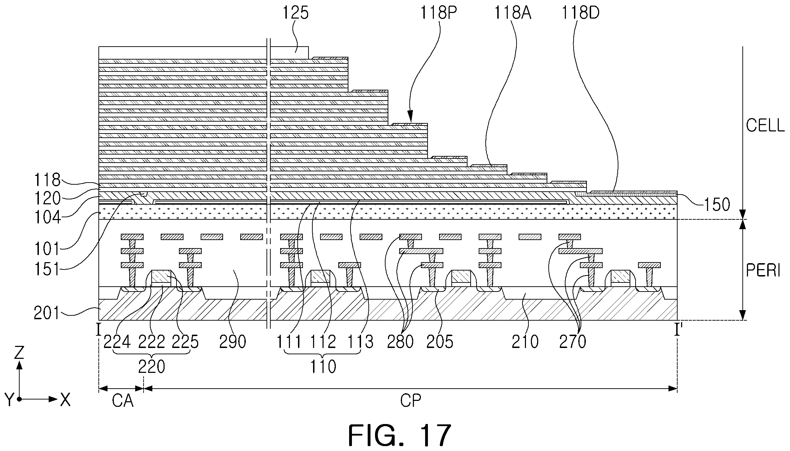

The dummy structure DG may be spaced apart from an end of the lowermost interlayer insulating layer 120L in the X-direction. A length by which the dummy structure DG is spaced apart from an end of the lowermost interlayer insulating layer 120L may be identical to or similar to a length of a region in which the gate electrode 130 has the first thickness T1 at a starting point of the gate pad region 130P. The dummy structure DG may be spaced apart from the second horizontal conductive layer 104 by the pad insulating layer 150. Accordingly, it is possible to reduce or prevent defects such as melting and loss of the second horizontal conductive layer 104 during the manufacturing process of the semiconductor device 100. This will be described in more detail with reference to FIGS. 17 to 21 below.

Each of the channel structures CH may be included in one memory cell string, and may be spaced apart from each other in rows and columns on the plate layer 101 in the cell array region CA. The channel structures CH may be arranged to form a grid pattern in an X-Y plane or may be arranged in a zigzag shape in one direction. The channel structures CH have a pillar shape and may have inclined side surfaces that become narrower as the channel structures CH approach the plate layer 101 depending on the aspect ratio. According to some example embodiments, at least some of the channel structures CH disposed in an end of the cell array region CA may be dummy channels.

The channel structures CH may include first and second channel structures CH1 and CH2 that are vertically stacked. The channel structures CH may have a shape in which lower first channel structures CH1 and upper second channel structures CH2 are connected, and may have bent portions due to differences in width in the connection region. However, according to example embodiments, the number of channel structures stacked in the Z-direction may be variously changed.

Each of the channel structures CH may include a channel layer 140, a channel dielectric layer 145, a channel buried insulating layer 147, and a channel pad 149, which are disposed in a channel hole. As illustrated in FIG. 3B, the channel layer 140 may be formed in an annular shape surrounding the channel buried insulating layer 147 disposed inside, but according to some example embodiments, the channel layer 140 may have a pillar shape such as a cylinder or a prism without the channel buried insulating layer 147. The channel layer 140 may be connected to the first horizontal conductive layer 102 in a lower portion thereof. The channel layer 140 may include a semiconductor material such as polycrystalline silicon or single crystalline silicon.

The channel dielectric layer 145 may be disposed between the gate electrodes 130 and the channel layer 140. Although not specifically illustrated, the channel dielectric layer 145 may include a tunneling layer, a charge storage layer, and a blocking layer, which are sequentially stacked from the channel layer 140. The tunneling layer may tunnel charges into the charge storage layer, and may include, for example, silicon oxide (SiO₂), silicon nitride (Si₃N₄), silicon oxynitride (SiON), or combinations thereof. The charge storage layer may be a charge trap layer or a floating gate conductive layer. The blocking layer may include silicon oxide (SiO₂), silicon nitride (Si₃N₄), silicon oxynitride (SiON), a high-κ dielectric material, or combinations thereof.

The channel pad 149 may be disposed only on an upper end of the upper second channel structure CH2. The channel pad 149 may include, for example, doped polycrystalline silicon. The channel layer 140, the channel dielectric layer 145, and the channel buried insulating layer 147 of the first channel structure CH1 may be connected to the channel layer 140, the channel dielectric layer 145, and the channel buried insulating layer 147 of the second channel structure CH2, respectively.

The support structures DCH may be spaced apart from each other in rows and columns on the plate layer 101 in the cell pad region CP. As illustrated in FIG. 1, support structures DCH may be arranged to surround each of the contact plugs 170 in four directions. However, in example embodiments, the arrangement shape of the support structures DCH may be variously changed. The support structures DCH may have a pillar shape and may have inclined side surfaces that become narrower as the support structures DCH approach the plate layer 101 depending on the aspect ratio.

The support structures DCH may have a circular shape, an oval shape, or a shape similar thereto, on the X-Y plane. A diameter or a maximum width of the support structures DCH may be larger than the diameter or the maximum width of the channel structures CH, but example embodiments of the present disclosure are not limited thereto. The support structures DCH may have an internal structure identical to or different from the channel structures CH. For example, the support structures DCH may not include a conductive layer, and may include an insulating material such as silicon oxide, silicon nitride, or silicon oxynitride.

The first and second separation regions MS1, MS2a and MS2b may be arranged to extend in the X-direction by penetrating through the gate electrodes 130. The first and second separation regions MS1, MS2a and MS2b may be arranged in parallel with each other. The first and second separation regions MS1, MS2a and MS2b may penetrate through entire gate electrodes 130 stacked on the plate layer 101, may further penetrate through the first and second horizontal conductive layers 102 and 104 and the horizontal insulating layer 110 therebelow, and may be connected to the plate layer 101. Outside the gate electrodes 130, the first and second separation regions MS1, MS2a and MS2b may penetrate through the cell region insulating layer 190, the dummy structure DG, the pad insulating layer 150, and the second horizontal conductive layer 104, and may be connected to the plate layer 101.

The first separation regions MS1 may extend as one in the X-direction, and the second separation regions MS2a and MS2b may extend intermittently between a pair of first separation regions MS1, or may only be deployed in some regions. For example, the second central separation regions MS2a may extend as one from the cell array region CA, and may extend intermittently in the cell pad region CP in the X-direction. The second auxiliary separation regions MS2b may be disposed only in the cell pad region CP, and may extend intermittently in the X-direction. However, in example embodiments, the arrangement order and number of the first and second separation regions MS1, MS2a and MS2b are not limited to those illustration in FIG. 1.

The first and second separation regions MS1, MS2a and MS2b may have a shape in which a width thereof decreases toward the plate layer 101 due to the high aspect ratio, but example embodiments of the present disclosure are not limited thereto. In some example embodiments, the first and second separation regions MS1, MS2a and MS2b may have a side surface, perpendicular to the upper surface of the plate layer 101. The first and second separation regions MS1, MS2a and MS2b may include an insulating material, and may include, for example, silicon oxide, silicon nitride, or silicon oxynitride.

As illustrated in FIG. 1, the upper separation regions US may extend in the cell array region CA in the X-direction, between the first separation regions MS1 and the second central separation regions MS2a and between the second central separation regions MS2a. The upper separation regions US may be disposed in a portion of the cell pad region CP and the cell array region CA so as to penetrate through some of the gate electrodes 130 including an uppermost first upper gate electrode 130U1 among the gate electrodes 130. The upper separation regions US may, for example, separate a total of three gate electrodes 130 from each other in the Y-direction, as illustrated in FIG. 2C. However, the number of gate electrodes 130 separated by the upper separation regions US may be variously changed in example embodiments. The upper separation regions US may include an insulating material, and may include, for example, silicon oxide, silicon nitride, or silicon oxynitride.

The contact plugs 170 may be connected to the gate pad regions 130P of the gate electrodes 130 in the cell pad region CP. The contact plugs 170 may penetrate through at least a portion of the cell region insulating layer 190, and may be connected to corresponding ones of the gate pad regions 130P of the gate electrodes 130 exposed upwardly, respectively. The contact plugs 170 may penetrate through the gate electrodes 130 below the gate pad regions 130P, and may penetrate through the second horizontal conductive layer 104, the horizontal insulating layer 110, and the plate layer 101 and may thus be connected to circuit interconnection lines 280 in the peripheral circuit region PERI. The contact plugs 170 may be spaced apart from the gate electrodes 130 below the gate pad regions 130P by the contact insulating layers 160. The contact plugs 170 may be spaced apart from the plate layer 101, the horizontal insulating layer 110, and the second horizontal conductive layer 104 by the substrate insulating layers 121. However, in some example embodiments, the contact plugs 170 may be connected to the gate pad regions 130P without penetrating through the gate electrodes 130.

Each of the contact plugs 170 may have a shape expanded horizontally from the gate pad region 130P. The contact plug 170 may include a vertical extension portion extending in the Z-direction, and a horizontal extension portion extending horizontally from the vertical extension portion and contacting the gate electrode 130. A length of the horizontal extension portion may be shorter than a length of the contact insulating layers 160 in a horizontal direction. The contact plugs 170 may be spaced apart from the gate electrodes 130 below the gate pad regions 130P (e.g., gate electrodes 130 that are not electrically connected) by the contact insulating layers 160.

The contact plugs 170 may include a conductive material, for example, at least one of tungsten (W), copper (Cu), aluminum (Al), or alloys thereof. In some example embodiments, the contact plugs 170 may include barrier layers extending along side surfaces and bottom surfaces thereof, and/or may have air gaps inside.

The contact insulating layers 160 may be arranged to surround the side surfaces of each of the contact plugs 170 below the gate pad regions 130P. The contact insulating layers 160 may be spaced apart from each other in the Z-direction around each of the contact plugs 170. The contact insulating layers 160 may be disposed on substantially the same level as a level of the gate electrodes 130. The contact insulating layers 160 may include an insulating material, and may include, for example, silicon oxide, silicon nitride, or silicon oxynitride.

The studs 180 and the cell interconnection lines 185 may be included in a cell interconnection structure electrically connected to the memory cells in the memory cell region CELL. The studs 180 may be connected to the channel structures CH and the contact plugs 170, and may electrically connect the channel structures CH and the gate electrodes 130 to the cell interconnection lines 185. The studs 180 may have a plug shape, and the cell interconnection lines 185 may have a line shape. In example embodiments, the number of plugs and interconnection lines included in the cell interconnection structure may be variously changed. The studs 180 and the cell interconnection lines 185 may include metal, and may include, for example, tungsten (W), copper (Cu), or aluminum (Al).

The cell region insulating layer 190 may be disposed to cover the stack structure of the gate electrodes 130 and the contact plugs 170. The cell region insulating layer 190 may be formed of an insulating material or may be formed of a plurality of insulating layers.

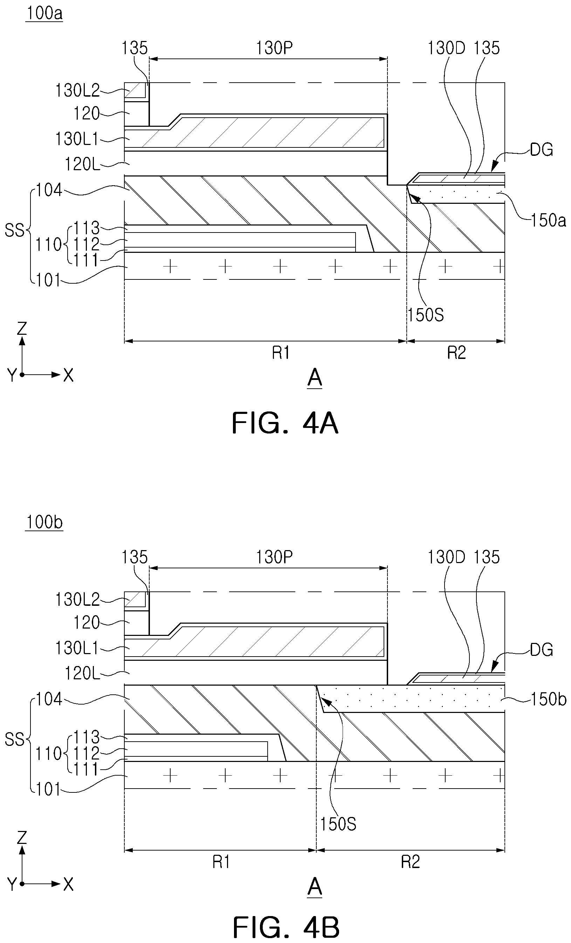

FIGS. 4A and 4B are schematic partially enlarged views of a semiconductor device according to some example embodiments. FIGS. 4A and 4B each illustrate a region corresponding to FIG. 3A.

Referring to FIG. 4A, in a semiconductor device 100a, an end of a pad insulating layer 150a may be disposed outside gate electrodes 130. Unlike the example embodiment of FIG. 3A, the pad insulating layer 150a may be disposed so as not to overlap a first lower gate electrode 130L1 in the Z-direction. In this example embodiment, a horizontal insulating layer 110 may extend relatively long in the X-direction, so that a second region R2, in which an upper surface of a second horizontal conductive layer 104 has a lower level by bending, may begin outside of the first lower gate electrode 130L1. The pad insulating layer 150a may be disposed on the second region R2 of the second horizontal conductive layer 104, and may be arranged to cover an entire lower surface of the dummy structure DG. In this manner, in example embodiments, positions of a side surface 150S of the second horizontal conductive layer 104 and an end including the side surface 150S may be variously changed in a range covering an entire lower surface of the dummy structure DG.

Referring to FIG. 4B, in a semiconductor device 100b, a pad insulating layer 150b may have a flat upper surface. Unlike in the example embodiment of FIG. 3A, a level of an upper surface of the pad insulating layer 150b may not be lowered even in a region exposed from the first lower gate electrode 130L1 and the lowermost interlayer insulating layer 120L. Accordingly, a level of a lower surface of the dummy structure DG may be substantially the same as the level of the lower surface of the lowermost interlayer insulating layer 120L.

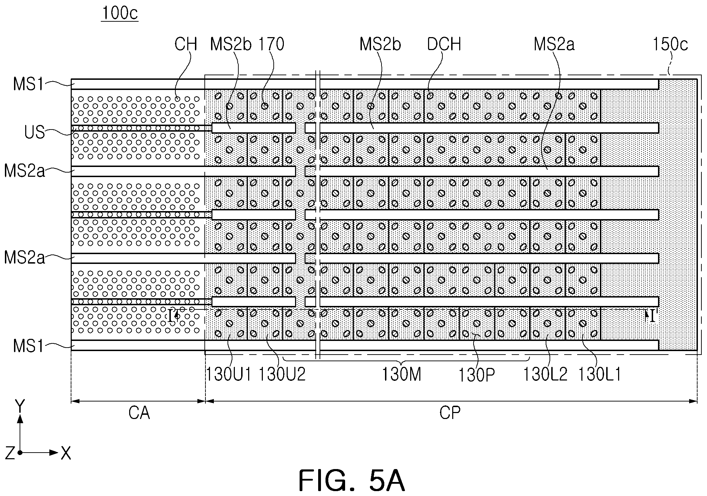

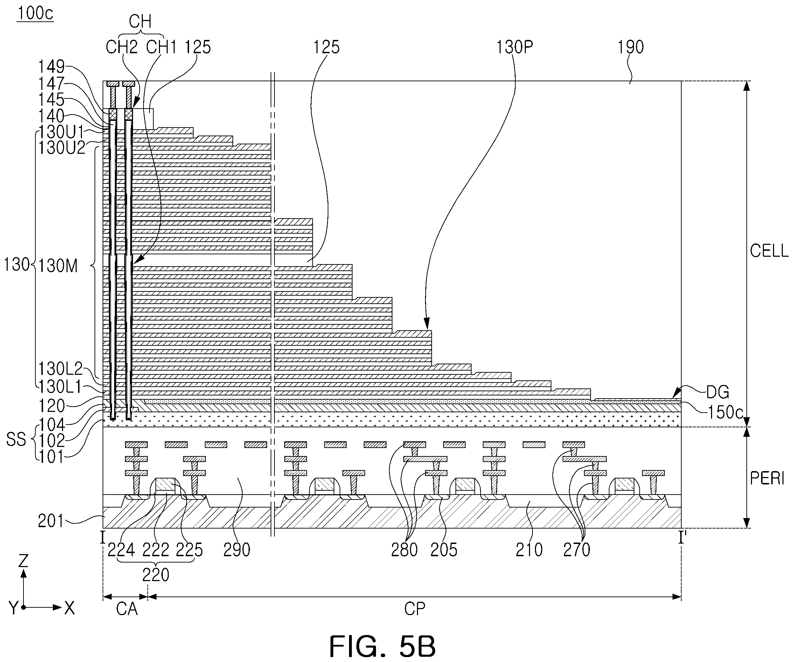

FIGS. 5A and 5B are a schematic plan view and a cross-sectional view of a semiconductor device according to an example embodiment, respectively. FIG. 5B illustrates a cross-section taken along line I-I' in FIG. 5A.

Referring to FIGS. 5A and 5B, in a semiconductor device 100c, an arrangement position of a pad insulating layer 150c may be different from an arrangement position in the embodiment of FIGS. 1 to 3C. One end of the pad insulating layer 150c may be disposed adjacently to an interface between a cell array region CA and a cell pad region CP. For example, the pad insulating layer 150c may be disposed throughout the cell pad region CP. In this example embodiment, the horizontal insulating layer 110 (see FIG. 2A) may not be disposed in the cell pad region CP. The pad insulating layer 150c may extend along a lower surface of a lowermost interlayer insulating layer 120, and may continue to extend beyond an end of the interlayer insulating layer 120 in the X-direction.

In some example embodiments, when the channel structures CH include dummy channel structures disposed in the cell array region CA adjacent to the cell pad region CP, an end of the pad insulating layer 150c may extend further into the cell array region CA. In some example embodiments, the end of the pad insulating layer 150c may be disposed outside the channel structures CH functioning as a memory cell string and may be variously changed in a range covering an entire lower surface of the dummy structure DG.

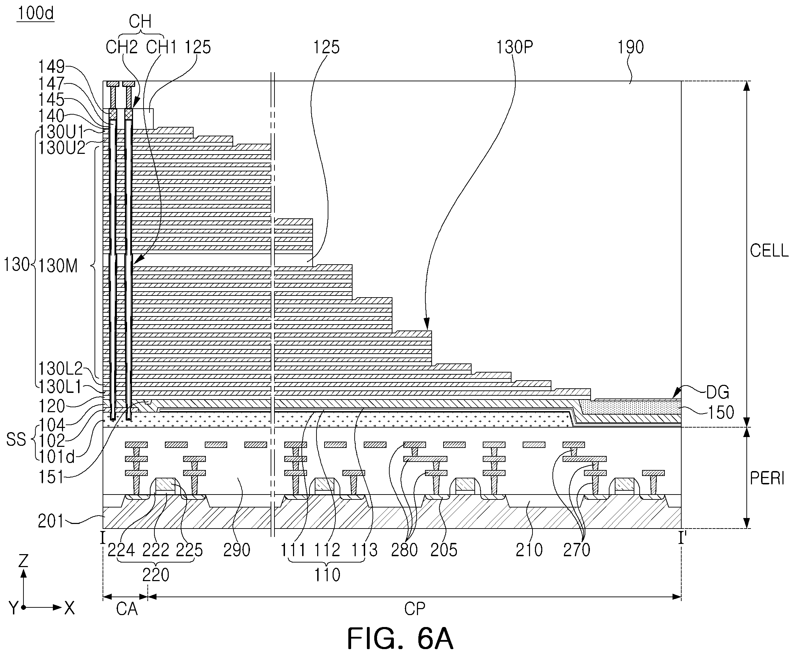

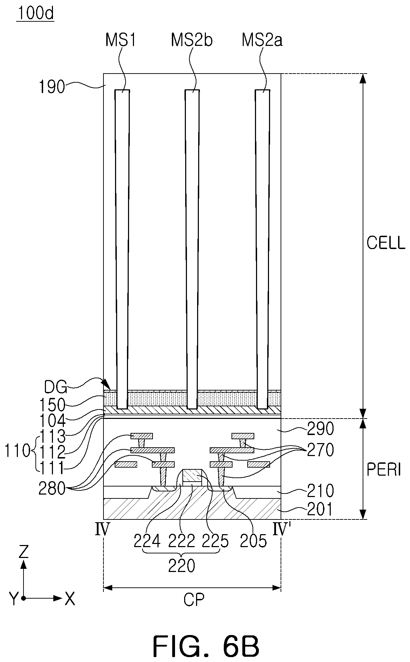

FIGS. 6A and 6B are schematic cross-sectional views of a semiconductor device according to an example embodiment. FIG. 6A illustrate a cross-section corresponding to FIG. 2A, and FIG. 6B illustrates a cross-section corresponding to FIG. 2D.

Referring to FIGS. 6A and 6B, in a semiconductor device 100d, a plate layer 101d may have an end disposed below a gate pad region 130P of a first lower gate electrode 130L1 or a bent portion bent to reduce a thickness thereof. The plate layer 101d may be completely removed from the outside of the gate pad region 130P of the first lower gate electrode 130L1 or may be removed by a predetermined thickness. A horizontal insulating layer 110 and a second horizontal conductive layer 104 may be bent along a step structure of the plate layer 101d (e.g., along the end or the bent portion of the plate layer 101d), and may extend onto the peripheral region insulating layer 290. The pad insulating layer 150 may be disposed on a region of an upper surface of the second horizontal conductive layer 104 in which a level thereof is lowered. The pad insulating layer 150 may have a maximum thickness equal to or smaller than a thickness of the plate layer 101d. In example embodiments, a position of the end or the bent portion of the plate layer 101d may be variously changed in the X-direction, between a planarizing insulating layer 151 and an end of a dummy structure DG.

In some example embodiments, at least one of the horizontal insulating layer 110 or the second horizontal conductive layer 104 may not extend below the pad insulation layer 150. In this case, at least one of the horizontal insulating layer 110 or the second horizontal conductive layer 104 may have an end in a similar position to an end of the plate layer 101d. For example, the horizontal insulating layer 110 may have an end extending from the end of the plate layer 101d. For example, the horizontal insulating layer 110 and the second horizontal conductive layer 104 may have ends extending from the end of the plate layer 101d. For example, the horizontal insulating layer 110 may extend as illustrated in FIG. 6A, and the second horizontal conductive layer 104 may have an end on an end of the plate layer 101d or a region adjacent thereto.

In a cell pad region CP, first and second separation regions MS1, MS2a and MS2b may penetrate through a dummy structure DG and a pad insulating layer 150 and have lower ends thereof disposed within the second horizontal conductive layer 104. However, in some example embodiments, the first and second separation regions MS1, MS2a and MS2b may penetrate through the second horizontal conductive layer 104, and further penetrate through a portion of the horizontal insulating layer 110.

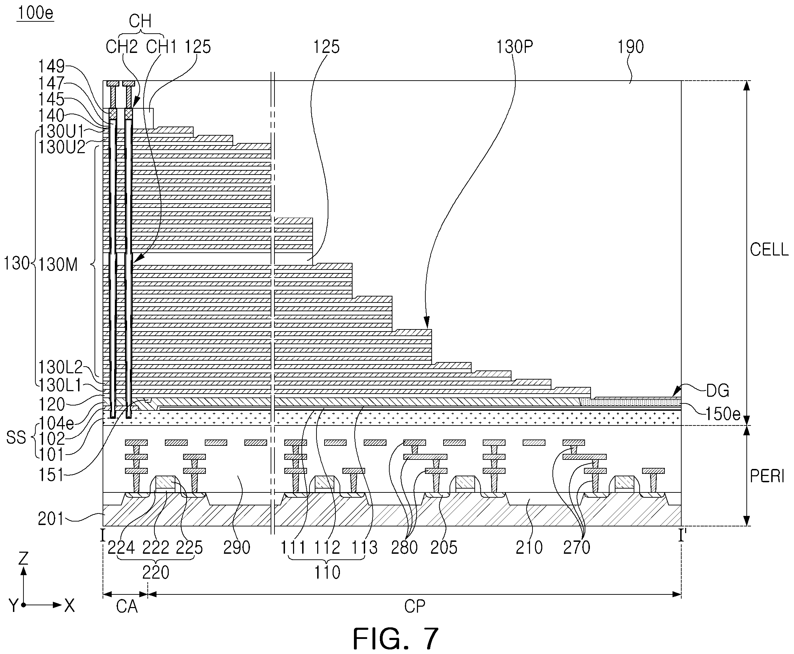

FIG. 7 is a schematic cross-sectional view of a semiconductor device according to an example embodiment. FIG. 7 illustrates a cross-section corresponding to FIG. 6A.

Referring to FIG. 7, in a semiconductor device 100e, a second horizontal conductive layer 104e may have an end having a sloped shape or a step structure disposed below a gate pad region 130P of a first lower gate electrode 130L1 or a bent portion bent to reduce a thickness thereof. A pad insulating layer 150e may be disposed on a region from which the second horizontal conductive layer 104 has been removed or a region in which a level of an upper surface of the second horizontal conductive layer 104 has been lowered. A lower surface of the pad insulating layer 150e may be in contact with a horizontal insulating layer 110, and one side surface thereof may be in contact with the second horizontal conductive layer 104. In this example embodiment, a pad insulating layer 150e may have a maximum thickness equal to or smaller than a thickness of the second horizontal conductive layer 104e. In example embodiments, a position of the end or the bent portion of the second horizontal conductive layer 104e may be variously changed in the X-direction, between a planarizing insulating layer 151 and an end of a dummy structure DG.

In some example embodiments, the horizontal insulating layer 110 may also have an end (e.g., an end portion) that does not extend below the pad insulating layer 150 but extends from an end of the second horizontal conductive layer 104e.

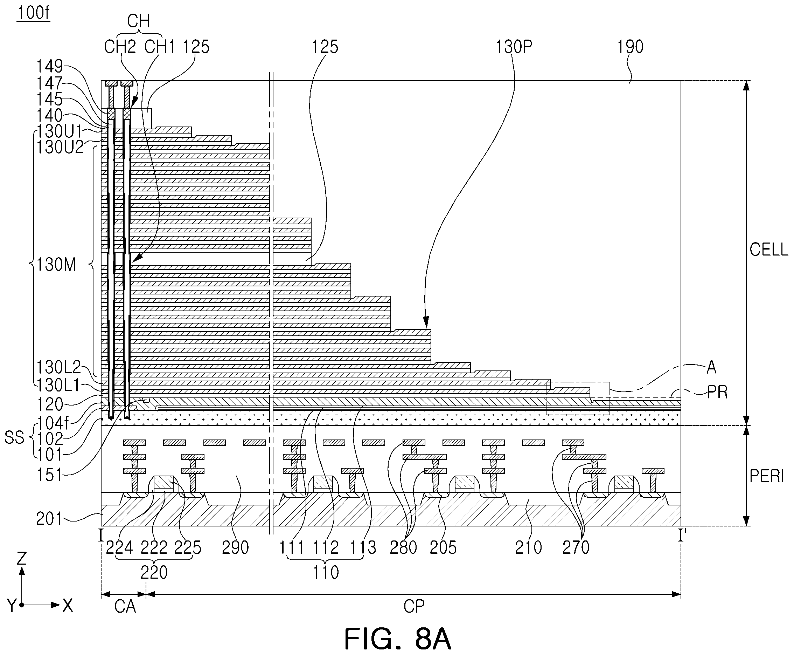

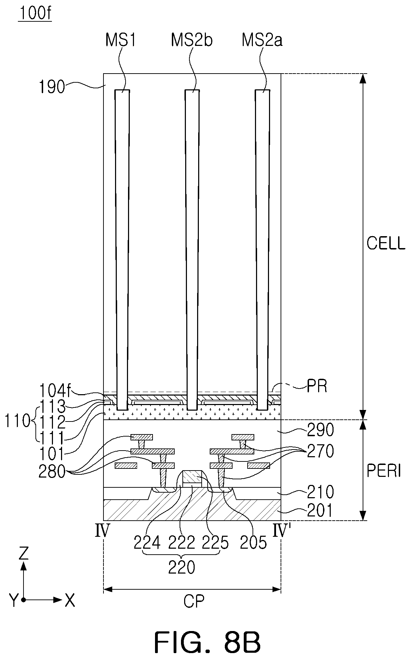

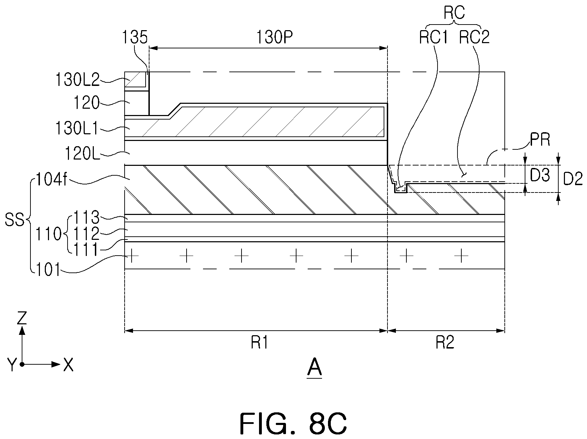

FIGS. 8A to 8C are schematic cross-sectional views and partially enlarged views of a semiconductor device according to an example embodiment. FIG. 8A illustrates a cross-section corresponding to FIG. 2A, FIG. 8B illustrates a cross-section corresponding to FIG. 2D, and FIG. 8C illustrates an enlarged view of region 'A' in FIG. 8A.

Referring to FIGS. 8A to 8C, a semiconductor device 100f may not include the pad insulating layer 150 and the dummy structure DG of FIGS. 1 to 3C, and may include a pad insulating region PR on a second horizontal conductive layer 104f outside a first lower gate electrode 130L1.

In this example embodiment, the horizontal insulating layer 110 may be disposed in a region of a cell pad region CP excluding a partial portion including the first and second separation regions MS1, MS2a and MS2b. Accordingly, as illustrated in FIG. 8A, a second horizontal conductive layer 104f may extend onto a horizontal insulating layer 110. The second horizontal conductive layer 104f may have a recessed region RC recessed at an upper surface thereof and may be outside a lowermost interlayer insulating layer 120L and the first lower gate electrode 130L1 in a plan view. The second horizontal conductive layer 104f may have an upper surface bent along the recessed region RC.

As illustrated in FIG. 8C, the recessed region RC may include a first recessed region RC1 and a second recessed region RC2, which are sequentially arranged from the gate electrodes 130 in the X-direction. The first recessed region RC1 may be adjacent to an end of the lowermost interlayer insulating layer 120 and may have a second depth D2, and the second recessed region RC2 may be outside the first recessed region RC1 and may have a third depth D3 smaller than the second depth D2.

In example embodiments, the shape of the first recessed region RC1, the shape of the second recessed region RC2 in a region connected to the first recessed region RC1, and the relative sizes of the second and third depths D2 and D3 may be variously changed. The recessed region RC may be filled with a portion of a cell region insulating layer 190, and the portion of the cell region insulating layer 190 that fills the recessed region RC may be referred to as a pad insulating region PR. The second horizontal conductive layer 104f may cover one side surface and a lower surface of the pad insulating region PR.

In the cell pad region CP, the first and second separation regions MS1, MS2a and MS2b may penetrate through the pad insulating region PR and the second horizontal conductive layer 104f and may be connected to a plate layer 101. The horizontal insulating layer 110 may be spaced apart from side surfaces of the first and second separation regions MS1, MS2a and MS2b.

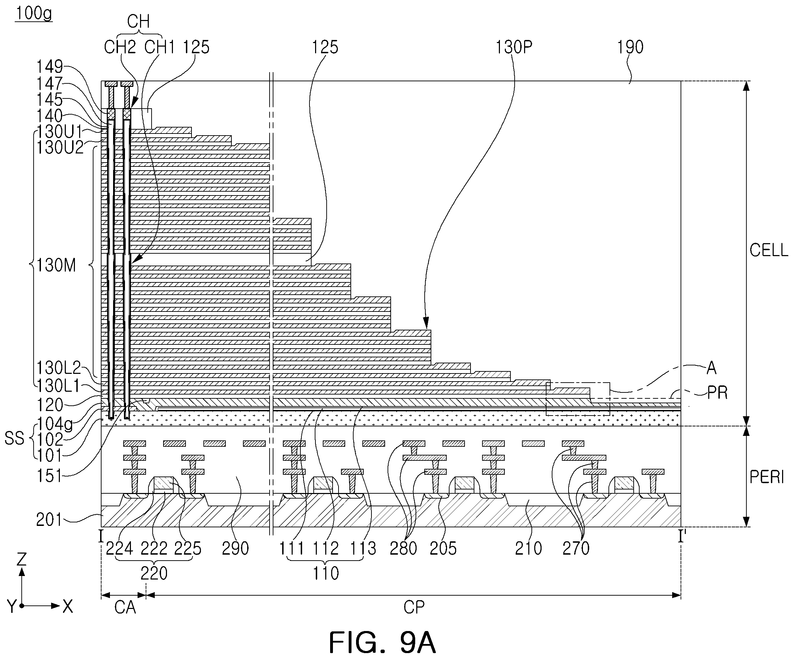

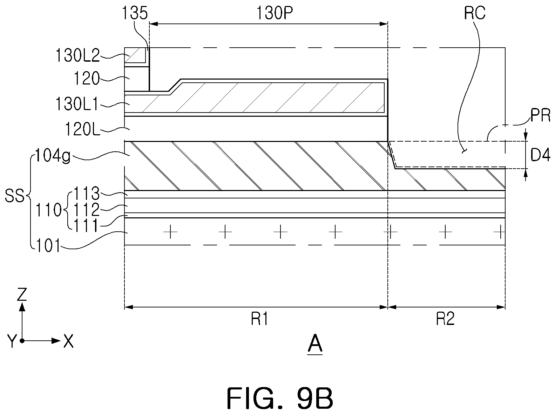

FIGS. 9A and 9B are a schematic cross-sectional view and a partially enlarged view of a semiconductor device according to an example embodiment. FIG. 9A illustrates a cross-section corresponding to FIG. 2A, and FIG. 9B illustrates an enlarged view of region 'A' of FIG. 9A.

Referring to FIG. 9A and 9B, a semiconductor device 100g may not include the pad insulating layer 150 and the dummy structure DG of FIGS. 1 to 3C, but may include a pad insulating region PR on a second horizontal conductive layer 104g outside a first lower gate electrode 130L1, like the example embodiment of FIGS. 8A to 8C. The second horizontal conductive layer 104g may have a recessed region RC recessed from an upper surface thereof, outside a lowermost interlayer insulating layer 120 and the first lower gate electrode 130L1. The second horizontal conductive layer 104g may have an upper surface bent along the recessed region RC.

In the second horizontal conductive layer 104g, the recessed region RC may be a single recessed region having a fourth depth D4, unlike the example embodiment of FIGS. 8A to 8C. The second horizontal conductive layer 104g may cover or define one side surface and a lower surface of the pad insulating region PR. The slope and shape of the side surface of the second horizontal conductive layer 104g defining the recessed region RC may be variously changed in example embodiments.

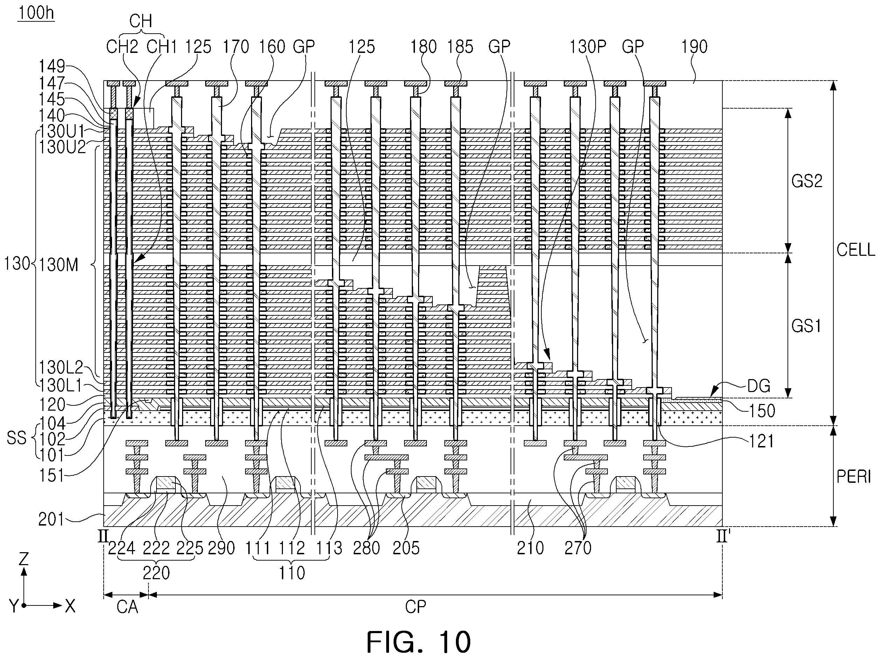

FIG. 10 is a schematic cross-sectional view of a semiconductor device according to an example embodiment. FIG. 10 illustrates a cross-section corresponding to FIG. 2B.

Referring to FIG. 10, a semiconductor device 100h may have a stack form of gate electrodes 130 and an arrangement of contact plugs 170 in a cell pad region CP, that are different from those in the example embodiment of FIG. 2B.

The gate electrodes 130 may form step-shaped step structures having a plurality of stepped regions GP. The gate electrodes 130 may have a shape in which a desired (or alternatively, predetermined) depth thereof is removed from an upper portion of any one of first and second stack structures GS1 and GS2 of the gate electrodes 130 in the stepped regions GP. The stepped regions GP may be arranged so as not to overlap each other in the Z-direction. On the stepped region GP of the first stack structure GS1, at least a portion of the gate electrodes 130 included in the second stack structures GS2 may extend horizontally. The stepped regions GP may be arranged in the order of the second stack structure GS2, the first stack structure GS1, and the second stack structure GS2 from the cell array region CA in the X-direction. However, in example embodiments, the arrangement shape, the arrangement order, and the depth of the stepped regions GP may be variously changed. In some example embodiments, gate electrodes 130 of an upper stack structure GS2 may not be disposed on the stepped regions GP of the first stack structure GS1.

The gate electrodes 130 may form first and second step structures in each of the stepped regions GP in an asymmetric shape in the X-direction. The first step structure may be relatively adjacent to the cell array region CA and may be a stepped structure in which a level thereof decreases in the X-direction, and the second step structure may be relatively far from the cell array region CA and may be a stepped structure or an inclined structure in which a level increases in the X-direction. For example, in each of the stepped regions GP, an inclination of the first step structure may be smaller than an inclination of the second step structure. However, in some example embodiments, the first and second step structures may have symmetrical shapes. In the first step structure, the gate electrodes 130 may be connected to the contact plugs 170, and in the second step structure, the gate electrodes 130 may form a dummy region or a dummy structure that is not connected to the contact plugs 170. In example embodiments, the specific shape of the step structure, the number of gate electrodes 130 included in each of the step structure, or the like, are not limited to the shape illustrated in FIG. 10. In some example embodiments, the gate electrodes 130 may also be arranged to have a step structure in the Y-direction.

A pad insulating layer 150 may be disposed outside the first lower gate electrode 130L1 in a lowermost portion of the first stack structure GS1, and a dummy structure DG may be disposed on the pad insulating layer 150. In some example embodiments, instead of the pad insulating layer 150 being disposed, the pad insulating region PR of the example embodiments of FIGS. 8A to 9B may be disposed.

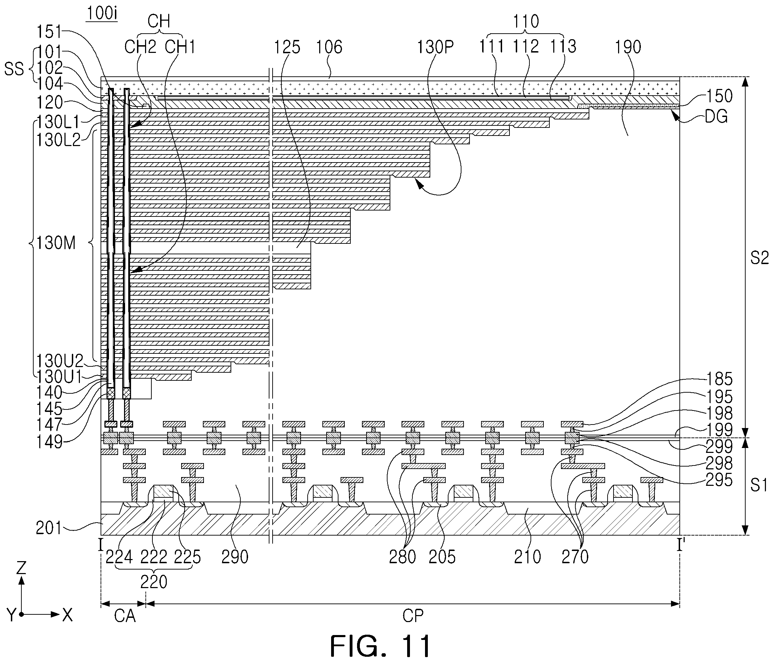

FIG. 11 is a schematic cross-sectional view of a semiconductor device according to an example embodiment. FIG. 11 illustrates a cross-section corresponding to FIG. 2A.

Referring to FIG. 11, a semiconductor device 100i may include a first semiconductor structure S1 and a second semiconductor structure S2 bonded using a wafer bonding method.

The description of the peripheral circuit region PERI described above with reference to FIGS. 1 to 2D may be applied to the first semiconductor structure S1. However, the first semiconductor structure S1 may further include first bonding vias 295, first bonding metal layers 298, and first bonding insulating layer 299, which are included in a bonding structure. The first bonding vias 295 may be disposed in an upper portion of circuit interconnection lines 280 in an uppermost portion, and may be connected to circuit interconnection lines 280. At least a portion of the first bonding metal layers 298 may be connected to the first bonding vias 295 on the first bonding vias 295. The first bonding metal layers 298 may be connected to second bonding metal layers 198 of the second semiconductor structure S2. The bonding metal layers 298 and the second bonding metal layers 198 may provide an electrical connection path for bonding the first semiconductor structure S1 and the second semiconductor structure S2. Some of the first bonding metal layers 298 may not be connected to circuit interconnection lines 280 in a lower portion and may be disposed only for bonding. The first bonding vias 295 and the first bonding metal layers 298 may include a conductive material, for example, copper (Cu). The first bonding insulating layer 299 may be disposed around the first bonding metal layers 298. The first bonding insulating layer 299 may also function as a diffusion barrier for the first bonding metal layers 298, and may include, for example, at least one of SiN, SiON, SiCN, SiOC, SiOCN, or SiO.

For the second semiconductor structure S2, unless otherwise specified, the description of the memory cell region CELL described above with reference to FIGS. 1 to 3C may be applied. The second semiconductor structure S2 may further include second bonding vias 195, second bonding metal layers 198, and a second bonding insulating layer 199, which are included in the bonding structure. The second semiconductor structure S2 may further include a passivation layer 106 covering an upper surface of a plate layer 101.

The second bonding vias 195 and the second bonding metal layers 198 may be disposed below cell interconnection lines 185 in a lowermost portion. The second bonding vias 195 may connect the cell interconnection lines 185 and the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 198 may include a conductive material, for example, copper (Cu). The second bonding insulating layer 199 may include, for example, at least one of SiO, SiN, SiCN, SiOC, SiON, or SiOCN.

The first and second semiconductor structures S1 and S2 may be bonded by bonding the first bonding metal layers 298 and the second bonding metal layers 198 and bonding the first bonding insulating layer 299 and the second bonding insulating layer 199. The bonding of the first bonding metal layers 298 and the second bonding metal layers 198 may be, for example, copper (Cu)-to-copper (Cu) bonding, and the bonding of the first bonding insulating layer 299 and the second bonding insulating layer 199 may be, for example, dielectric-to-dielectric bonding such as SiCN-to-SiCN bonding. The first and second semiconductor structures S1 and S2 may be bonded by hybrid bonding including copper (Cu)-to-copper (Cu) bonding and dielectric-to-dielectric bonding.

The passivation layer 106 may be disposed on an upper surface of a plate layer 101 and may protect the semiconductor device 100i. The passivation layer 106 may include at least one of an insulating material, for example, silicon oxide, silicon nitride, or silicon carbide.

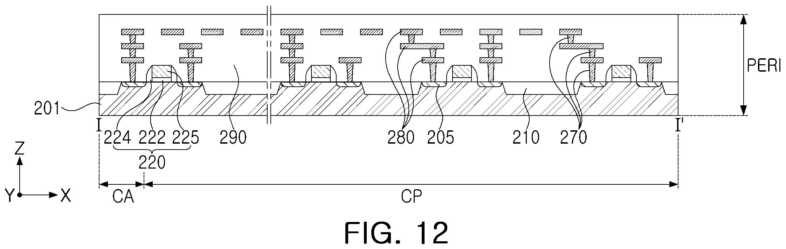

FIGS. 12 to 23 are schematic cross-sectional views illustrating a method of manufacturing a semiconductor device according to an example embodiment. Each of FIGS. 12 to 19 illustrates a cross-section corresponding to FIG. 2A, and FIGS. 20 to 23 illustrate cross-sections corresponding to FIG. 2B.

Referring to FIG. 12, circuit elements 220, a circuit interconnection structure, and a peripheral region insulating layer 290, which are included in a peripheral circuit region PERI, may be formed on a substrate 201.

First, device isolating layers 210 may be formed within the substrate 201, and a circuit gate dielectric layer 222 and a circuit gate electrode 225 may be sequentially formed on the substrate 201. The device isolating layers 210 may be formed by, for example, a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of at least one of polycrystalline silicon or a metal silicide layer, but example embodiments of the present disclosure are not limited thereto. Next, a spacer layer 224 and impurity regions 205 may be formed on both sidewalls of the circuit gate dielectric layer 222 and the circuit gate electrode 225. According to some example embodiments, the spacer layer 224 may be formed of a plurality of layers. The impurity regions 205 may be formed by performing an ion implantation process.

Circuit contact plugs 270 in a circuit interconnection structure may be formed by forming a portion of the peripheral region insulating layer 290, and then partially etching and removing the peripheral region insulating layer 290 and filling the removed portion with a conductive material. The circuit interconnection lines 280 may be formed, for example, by depositing a conductive material and then patterning the conductive material.

The peripheral region insulating layer 290 may be formed of a plurality of insulating layers. The peripheral region insulating layer 290 may be a portion of each operation of forming the circuit interconnection structure. Accordingly, the peripheral circuit region PERI may be formed.

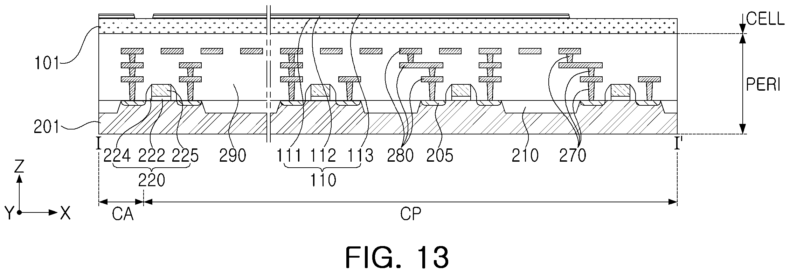

Referring to FIG. 13, a plate layer 101 and a horizontal insulating layer 110 provided with a memory cell region CELL may be formed on the peripheral circuit region PERI.

The plate layer 101 may be formed on the peripheral region insulating layer 290. The plate layer 101 may be formed of, for example, polycrystalline silicon and may be formed through a CVD process. Polycrystalline silicon included in the plate layer 101 may include impurities.

The first to third horizontal insulating layers 111, 112 and 113 included in the horizontal insulating layer 110 may be sequentially stacked on the plate layer 101. The horizontal insulating layer 110 may be a layer in which a region, for example, a region in the cell array region CA, is replaced with the first horizontal conductive layer 102 (see FIG. 2A) through a subsequent process. The first and third horizontal insulating layers 111 and 113 may include a material different from a material of the second horizontal insulating layer 112. For example, the first and third horizontal insulating layers 111 and 113 may be formed of the same material as the interlayer insulating layers 120, and the second horizontal insulating layer 112 may be formed of the same material as subsequent sacrificial insulating layers 118.

Some regions of the horizontal insulating layer 110 may be removed through a patterning process. For example, in the cell pad region CP, the horizontal insulating layer 110 may be removed from a region corresponding to a region of the pad insulating layer 150, regions of the first and second separation regions MS1, MS2a and MS2b, a boundary of the cell array region CA and the cell pad region CP of FIG. 1.

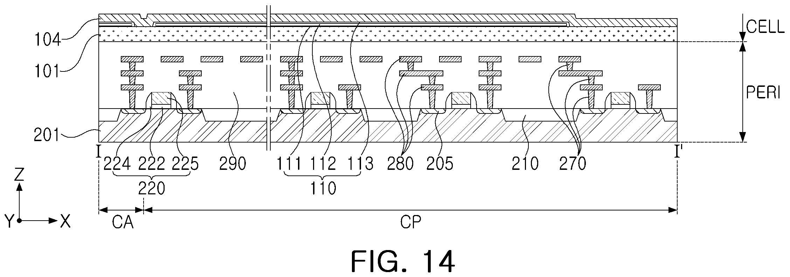

Referring to FIG. 14, a second horizontal conductive layer 104 may be formed on the plate layer 101 and the horizontal insulating layer 110.

Before forming the second horizontal conductive layer 104, the second horizontal insulating layer 112 may be partially removed from exposed side surfaces of the horizontal insulating layer 110, an insulating material may be additionally deposited on the removed portion, and then, a portion of the deposited insulating material may be etched. The insulating material may include the same material as the first and third horizontal insulating layers 111 and 113, and for convenience, the insulating material is described as being included in a portion of the third horizontal insulating layer 113. Accordingly, in ends of the horizontal insulating layer 110, side surfaces of the first and second horizontal insulating layers 111 and 112 may be covered with the third horizontal insulating layer 113.

The second horizontal conductive layer 104 may be formed on the horizontal insulating layer 110, and may be bent in a region from which the horizontal insulating layer 110 has been removed and may be in contact with the plate layer 101.

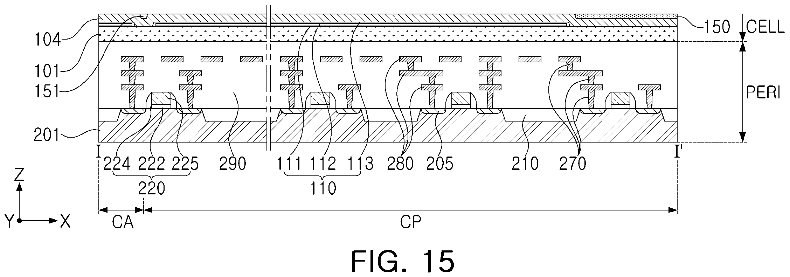

Referring to FIG. 15, a pad insulating layer 150 and a planarizing insulating layer 151 may be formed to fill a region in which the second horizontal conductive layer 104 is bent.

The pad insulating layer 150 and the planarizing insulating layer 151 may be formed by depositing an insulating material on an entire structure and performing a planarizing process such as a chemical mechanical polishing (CMP) process. In this operation, before the deposition of the insulating material, the plate layer 101, the horizontal insulating layer 110, and the second horizontal conductive layer 104 may be removed from some regions, and the insulating material may be deposited together in the regions. The substrate insulating layers 121 illustrated in FIG. 2B may also be formed together with the pad insulating layer 150 and the planarizing insulating layer 151 in this operation. Upper surfaces of the pad insulating layer 150, the planarizing insulating layer 151, and the substrate insulating layers 121 may be substantially coplanar with an upper surface of the second horizontal conductive layer 104.

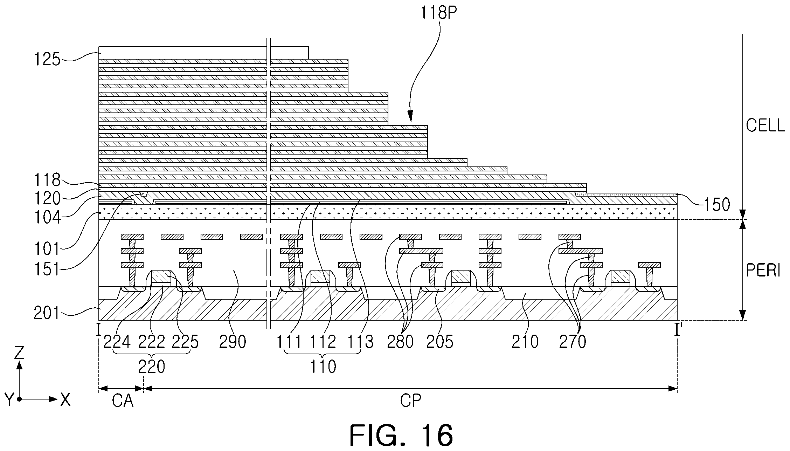

Referring to FIG. 16, sacrificial insulating layers 118 and interlayer insulating layers 120 forming a lower mold structure may be alternately stacked on the second horizontal conductive layer 104, and a step structure of the sacrificial insulating layers 118 and the interlayer insulating layers 120 may be formed.

The lower mold structure may be formed by alternately stacking the sacrificial insulating layers 118 and the interlayer insulating layers 120 on the second horizontal conductive layer 104 at a height at which the first channel structures CH1 (see FIG. 2A) of the channel structures CH (see FIG. 2A) are disposed. A relatively thick upper interlayer insulating layer 125 may be formed on the uppermost one of the interlayer insulating layers 120.

The sacrificial insulating layers 118 may be a layer at least partially replaced with the gate electrodes 130 (see FIG. 2A) through a subsequent process. The sacrificial insulating layers 118 may be formed of a material different from a material of the interlayer insulating layers 120, and may be formed of a material that may be etched with etch selectivity under specific etching conditions for the interlayer insulating layers 120. For example, the interlayer insulating layer 120 and the upper interlayer insulating layer 125 may be formed of at least one of silicon oxide or silicon nitride, and the sacrificial insulating layers 118 may be formed of a material different from a material of the interlayer insulating layer 120 and the upper interlayer insulating layer 125 selected from silicon, silicon oxide, silicon carbide, and silicon nitride. In some example embodiments, thicknesses of the interlayer insulating layers 120 may not all be the same. The thickness of the interlayer insulating layers 120 and the sacrificial insulating layers 118 and the number of films included may be variously changed from what is illustrated.

Next, the stepped structure may be formed by partially removing the sacrificial insulating layers 118 and the interlayer insulating layers 120 so that the sacrificial insulating layers 118 extend to different lengths in the cell pad region CP. The stepped structure may be formed by repeatedly performing a process of performing a photolithography process to form a mask layer and performing an etching process and then partially removing the mask layer through a trim process and performing an etching process. First, after forming a stepped structure in which the interlayer insulating layers 120 remain at a reduced thickness on the sacrificial insulating layers 118, the remaining interlayer insulating layers 120 may be removed to expose the sacrificial insulating layers 118. Accordingly, the sacrificial insulating layers 118 may be included in a step structure in desired (or alternatively, predetermined) units, and sacrificial pad regions 118P disposed in an uppermost portion of the sacrificial insulating layers 118 may be exposed upwardly. During the process of removing the remaining interlayer insulating layers 120, a portion of the pad insulating layer 150 may be removed from an exposed upper surface of the pad insulating layer 150. Accordingly, the pad insulating layer 150 may have a lowered upper surface outside the lower mold structure.

Referring to FIG. 17, pad sacrificial layers 118A may be formed on the sacrificial pad regions 118P.

First, one preliminary pad sacrificial layer may be formed to cover an entire stepped structure. The preliminary pad sacrificial layer may include a material of the same type as the sacrificial insulating layers 118 and a material having an etch rate different from an etch rate of the sacrificial insulating layers 118. For example, since the preliminary pad sacrificial layer and the sacrificial insulating layers 118 include silicon nitride but have different physical properties, the degree of etching may vary under certain etching conditions.

The preliminary pad sacrificial layer may be selectively removed from the side surfaces of the step structure of the lower mold structure. The removal process may be performed, for example, after changing the physical properties of horizontally deposited regions of the preliminary pad sacrificial layer using plasma. Accordingly, the preliminary pad sacrificial layer may remain on the sacrificial pad regions 118P and the pad insulating layer 150, thus forming pad sacrificial layers 118A and dummy sacrificial layer 118D. The pad sacrificial layers 118A and the dummy sacrificial layer 118D may be formed to be spaced apart from ends of adjacent interlayer insulating layers 120 in the X-direction. Hereinafter, the pad sacrificial layers 118A are illustrated and described as being included in a portion of the sacrificial insulating layers 118. The dummy sacrificial layer 118D may be formed on the pad insulating layer 150, and may be spaced apart from the second horizontal conductive layer 104 without contacting the second horizontal conductive layer 104 by the pad insulating layer 150.

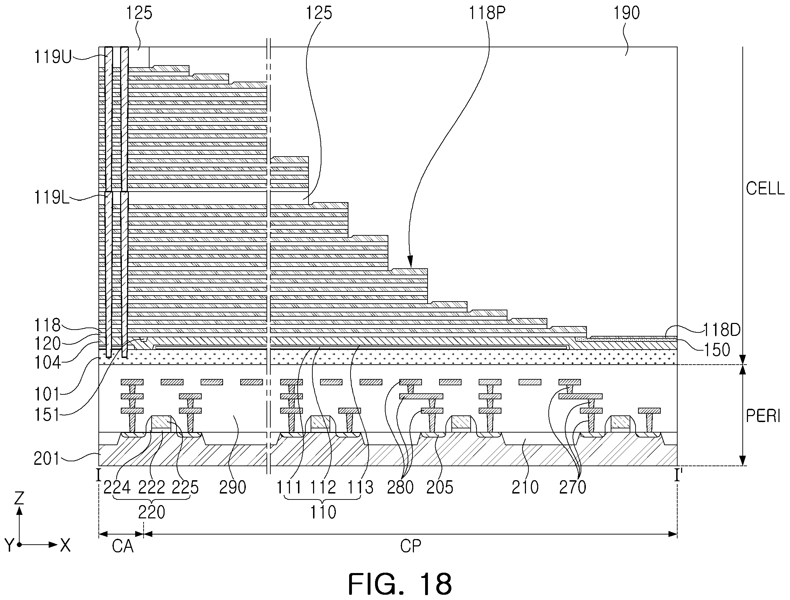

Referring to FIG. 18, first channel sacrificial layers 119L penetrating through the lower mold structure may be formed, and an upper mold structure and second channel sacrificial layers 119U may be formed.

First, a portion of the cell region insulating layer 190 covering the lower mold structure may be formed. The first channel sacrificial layers 119L may be formed in a position corresponding to the first channel structures CH1 (see FIG. 2A) in the cell array region CA. The first channel sacrificial layers 119L may be formed by forming lower channel holes to penetrate through the lower mold structure, depositing a material included in the first channel sacrificial layers 119L in the lower channel holes and performing a fattening process. The first channel sacrificial layers 119L may include, for example, polycrystalline silicon, a carbon-based material, or a metallic material. In some example embodiments, when forming the first channel sacrificial layers 119L, vertical sacrificial layers may also be formed in regions corresponding to lower regions of the contact plugs 170 of FIG. 2B.

The upper mold structure may be formed by alternately stacking the sacrificial insulating layers 118 and the interlayer insulating layers 120 at a height at which the second channel structures CH2 (see FIG. 2A) of the channel structures CH (see FIG. 2A) are disposed. For the upper mold structure, the above-described process with reference to FIGS. 16 and 17 may be performed in the same manner to form sacrificial pad regions 118P. In some example embodiments, the process of forming the sacrificial pad regions 118P may be performed simultaneously on the lower mold structure and the upper mold structure.

The second channel sacrificial layers 119U may be formed in positions corresponding to the second channel structures CH2 in the cell array region CA. The second channel sacrificial layers 119U may be formed to be connected to the first channel sacrificial layers 119L, respectively. The second channel sacrificial layers 119U may be formed by depositing the same material as the first channel sacrificial layers 119L. In some example embodiments, when forming the second channel sacrificial layers 119U, vertical sacrificial layers may also be formed in regions corresponding to the upper regions of the contact plugs 170 of FIG. 2B.

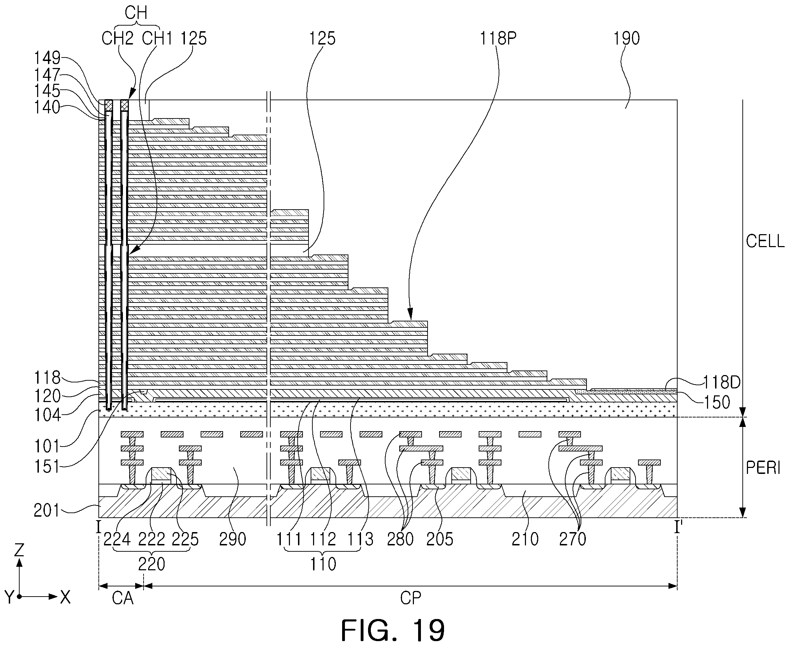

Referring to FIG. 19, channel structures CH penetrating through the lower mold structure and the upper mold structure may be formed.

The channel structures CH may be formed by removing the first and second channel sacrificial layers 119L and 119U from the cell array region CA to form hole-shaped channel holes, and then sequentially depositing a channel dielectric layer 145, a channel layer 140, a channel buried insulating layer 147, and a channel pad 149 in the channel holes.

The channel dielectric layer 145 may be formed to have a uniform thickness using an ALD or CVD process. The channel layer 140 may be formed on the channel dielectric layer 145 within the channel holes. The channel buried insulating layer 147 may be formed to fill the channel holes and may be formed of an insulating material. The channel pad 149 may be formed by partially removing the channel buried insulating layer 147 from an upper portion of the channel hole and then depositing a conductive material. The conductive material may include, for example, polycrystalline silicon.

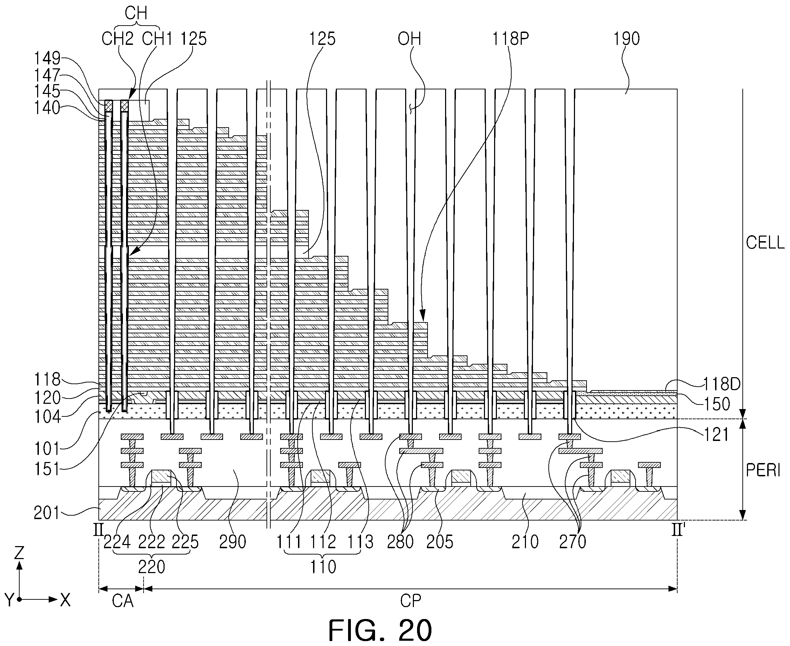

Referring to FIG. 20, through-holes OH penetrating through the lower mold structure and the upper mold structure may be formed.

The through-holes OH may be formed in regions corresponding to the contact plugs 170 of FIG. 2B in the cell pad region CP. The through-holes OH may penetrate through the cell region insulating layer 190, the sacrificial insulating layers 118 and the interlayer insulating layers 120, and may be formed to penetrate through the substrate insulating layers 121 in a lower portion thereof. Circuit interconnection lines 280 may be exposed through bottom surfaces of the through-holes OH.

In some example embodiments, in the case of forming vertical sacrificial layers even in regions corresponding to the contact plugs 170 when forming the first and second channel sacrificial layers 119L and 119U, the through-holes OH may be formed by removing the vertical sacrificial layers.

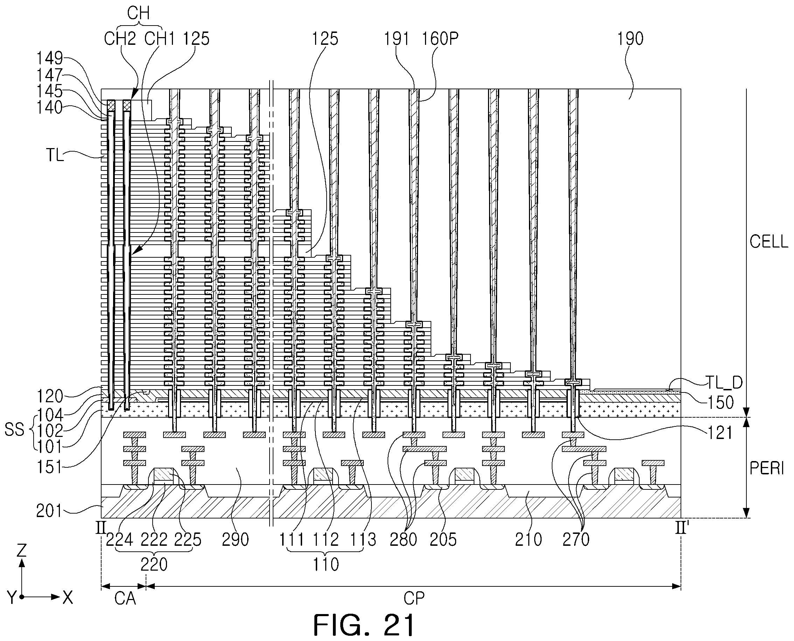

Referring to FIG. 21, preliminary contact insulating layers 160P and vertical sacrificial layers 191 may be formed in the through-holes OH, first horizontal conductive layer 102 may be formed, and the sacrificial insulating layers 118 may be removed.

First, some of the sacrificial insulating layers 118 exposed through the through-holes OH may be removed. Tunnel portions may be formed by removing the sacrificial insulating layers 118 to a desired (or alternatively, predetermined) length around the through-holes OH. The tunnel portions are formed to have a relatively short length in the sacrificial pad regions 118P, and may be formed to have a relatively long length in the sacrificial insulating layers 118.

For example, initially, on the contrary, the tunnel portions may be formed to be relatively long in the sacrificial pad regions 118P. This may be because the sacrificial pad regions 118P include regions in which an etch rate thereof is relatively faster than an etch rate of the sacrificial insulating layers 118 therebelow. Next, an additional sacrificial layer may be formed in the through-holes OH and the tunnel portions. The sacrificial layer may be formed of a material in which an etch rate thereof is slower than an etch rate of the sacrificial insulating layers 118. Next, a portion of the sacrificial layer and sacrificial insulating layers 118 may be removed, and in this case, the sacrificial layer may remain in the sacrificial pad regions 118P, and a portion of the sacrificial insulating layers 118 may be further removed from the lower portion after the sacrificial layer is removed. Accordingly, the tunnel portions may ultimately be formed to have a relatively short length in the sacrificial pad regions 118P.

Preliminary contact insulating layers 160P may be formed by depositing an insulating material in the through-holes OH and the tunnel portions. The preliminary contact insulating layers 160P may be formed on sidewalls of the through-holes OH, and may fill the tunnel portions. In the sacrificial pad regions 118P, the through-holes OH may not completely fill the tunnel portions.

The vertical sacrificial layers 191 may fill the through-holes OH and the tunnel portions of the sacrificial pad regions 118P. The vertical sacrificial layers 191 may include a material different from the preliminary contact insulating layers 160P, for example, polycrystalline silicon.

Next, openings extending to the plate layer 101 by penetrating through the sacrificial insulating layers 118 and the interlayer insulating layers 120 may be formed in the positions of the first and second separation regions MS1, MS2a and MS2b (see FIG. 1). Next, an etch-back process may be performed while forming additional sacrificial spacer layers in the openings, and in the cell array region CA, the horizontal insulating layer 110 may be selectively removed, and a portion of the exposed channel dielectric layer 145 may also be removed. After forming the first horizontal conductive layer 102 by depositing a conductive material in a region from which the horizontal insulating layer 110 has been removed, the sacrificial spacer layers may be removed within the openings. Through this process, the first horizontal conductive layer 102 may be formed in the cell array region CA.

Next, the sacrificial insulating layers 118 may be selectively removed with respect to the interlayer insulating layers 120, the second horizontal conductive layer 104, and the preliminary contact insulating layers 160P, using, for example, wet etching. Accordingly, tunnel portions TL may be formed in regions from which the sacrificial insulating layers 118 have been removed. In this operation, the dummy sacrificial layer 118D may also be removed along with the sacrificial insulating layers 118 to form a dummy tunnel portion TL_D. Since the pad insulating layer 150 is disposed on a bottom surface of the dummy tunnel portion TL_D, when removing the dummy sacrificial layer 118D, it may be possible to reduce or prevent the second horizontal conductive layer 104 from being damaged or prevent a portion of the second horizontal conductive layer 104 from being removed altogether.

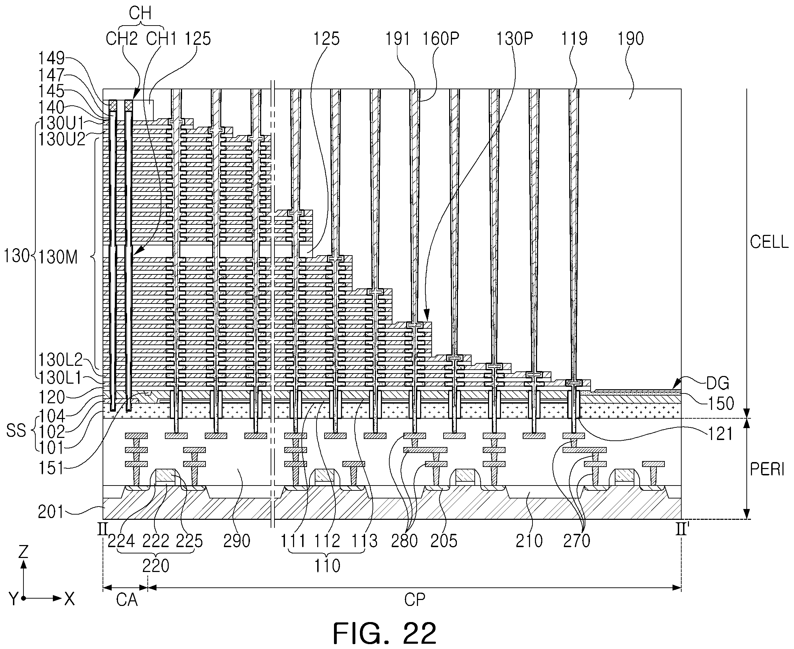

Referring to FIG. 22, gate electrodes 130 may be formed.

The gate electrodes 130 may be formed by first forming gate dielectric layers 135 (see FIG. 3A) in the tunnel portions TL and then depositing a conductive material. The conductive material may include metal, polycrystalline silicon, or metal silicide material. When forming the gate electrodes 130, the gate dielectric layer 135 and the conductive material may be equally deposited in the dummy tunnel portion TL_D to form a dummy structure DG.

After forming the gate electrodes 130, the first and second separation regions MS1, MS2a and MS2b may be formed by depositing an insulating material in the openings formed in the regions of the first and second separation regions MS1, MS2a and MS2b (see FIG. 1).

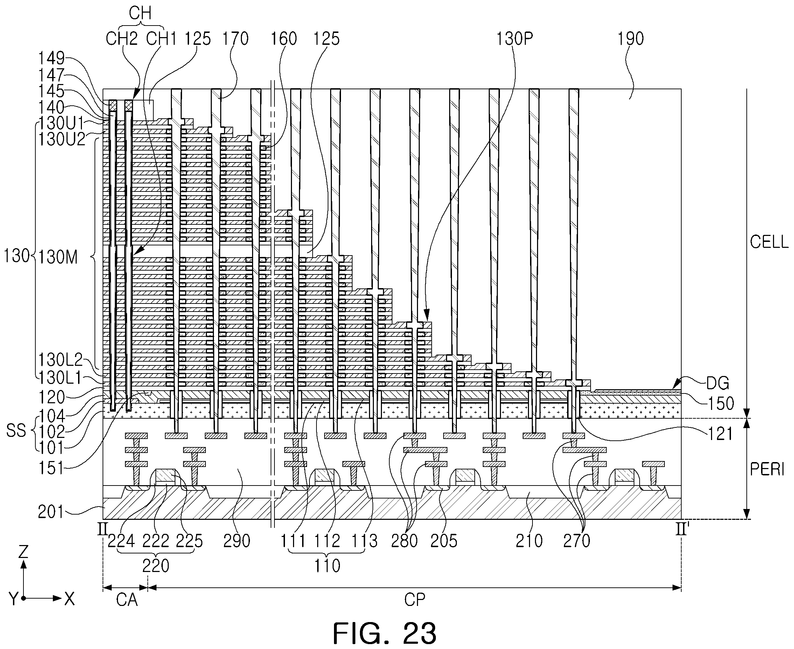

Referring to FIG. 23, the vertical sacrificial layers 191 in the through-holes OH may be removed, and contact plugs 170 may be formed.

The vertical sacrificial layers 191 may be selectively removed with respect to the interlayer insulating layers 120 and the gate electrodes 130. After the vertical sacrificial layers 191 are removed, some of the exposed preliminary contact insulating layers 160P may also be removed. In this case, all the preliminary contact insulating layers 160P may be removed from the gate pad regions 130P, and the preliminary contact insulating layers 160P may remain therebelow to form contact insulating layers 160. In the gate pad regions 130P, when the gate dielectric layers 135 (see FIG. 3A) are exposed after the preliminary contact insulating layers 160P are removed, some of the gate dielectric layers 135 may also be removed to expose side surfaces of the conductive layers of the gate electrodes 130.

The contact plugs 170 may be formed by depositing a conductive material in the through-holes OH. The contact plugs 170 may be formed to have horizontal extension portions extending horizontally from the gate pad regions 130P, and may thus be physically and electrically connected to the gate electrodes 130.

Next, referring to FIGS. 2A and 2B together, studs 180 and cell interconnection lines 185 connected to the contact plugs 170 and upper ends of the channel structures CH may be formed to manufacture the semiconductor device 100.

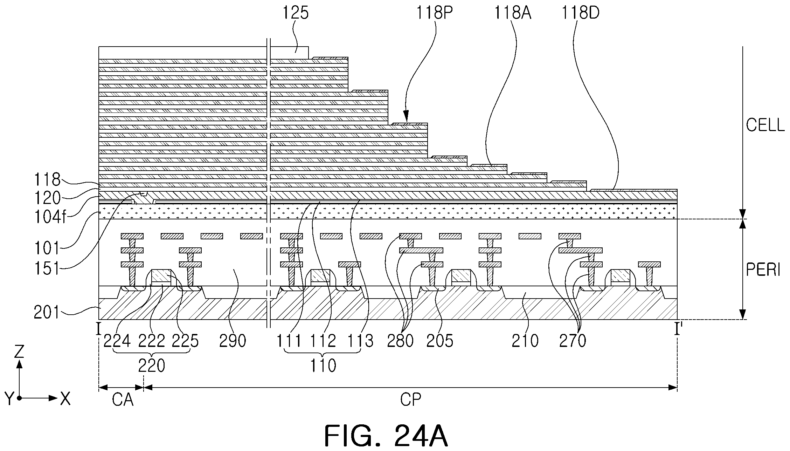

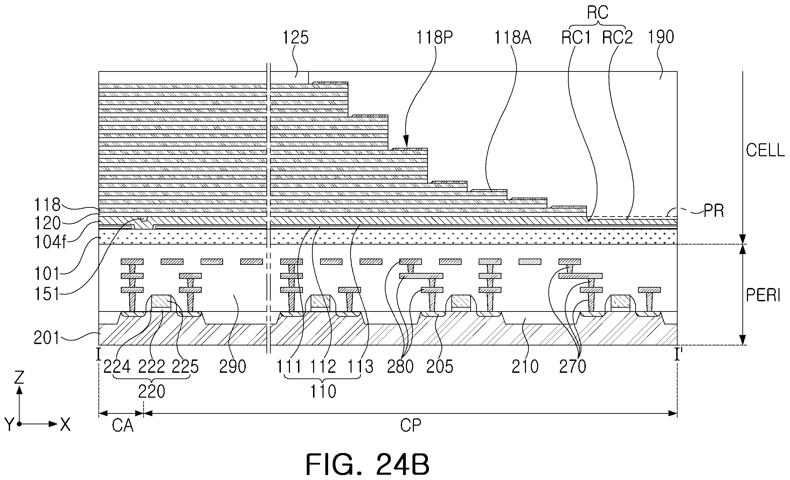

FIGS. 24A and 24B are schematic cross-sectional views illustrating a method of manufacturing a semiconductor device according to an example embodiment. Each of FIGS. 24A and 24B illustrates cross-sections corresponding to FIG. 8A.

Referring to FIG. 24A, a plate layer 101, a horizontal insulating layer 110, and a second horizontal conductive layer 104 may be formed on a peripheral circuit region PERI, a lower mold structure may be formed, and pad sacrificial layers 118A and dummy sacrificial layers 118D may be formed.

For a formation process of the same constituent, each process described above with reference to FIGS. 12 to 17 may be equally applied. However, in this example embodiment, unlike the process described above with reference to FIG. 13, a horizontal insulating layer 110 may not have an end in a cell pad region CP. Accordingly, a second horizontal conductive layer 104f may also extend without being bent in this operation. Accordingly, in the process described above with reference to FIG. 15, a pad insulating layer 150 may not be formed, but only the planarizing insulating layer 151 and the substrate insulating layers 121 (see FIG. 2B) may be formed. In this embodiment, the dummy sacrificial layer 118D may be formed on an upper surface of the second horizontal conductive layer 104f.

Referring to FIG. 24B, a dummy sacrificial layer 118D may be removed.

After forming a mask layer covering a stepped structure of the lower mold structure and exposing the dummy sacrificial layer 118D, the dummy sacrificial layer 118D may be removed. The dummy sacrificial layer 118D may be removed by an etching process, and during the etching process, the dummy sacrificial layer 118D may be removed and a portion of the exposed second horizontal conductive layer 104f may also be removed. Accordingly, the second horizontal conductive layer 104f may have a recessed region RC outside the lower mold structure. The recessed region RC may include a first recessed region RC1 formed to be relatively deep in a region exposed from the dummy sacrificial layer 118D, and a second recessed region RC2 formed to be relatively shallow in a region covered with the dummy sacrificial layer 118D.

The cell region insulating layer 190 may be formed to fill the recessed region RC, and a region of the cell region insulating layer 190 filling the recessed region RC may be referred to as a pad insulating region PR.

Next, the semiconductor device 100f of FIGS. 8A to 8C may be manufactured by identically performing the processes described above with reference to FIGS. 18 to 23.

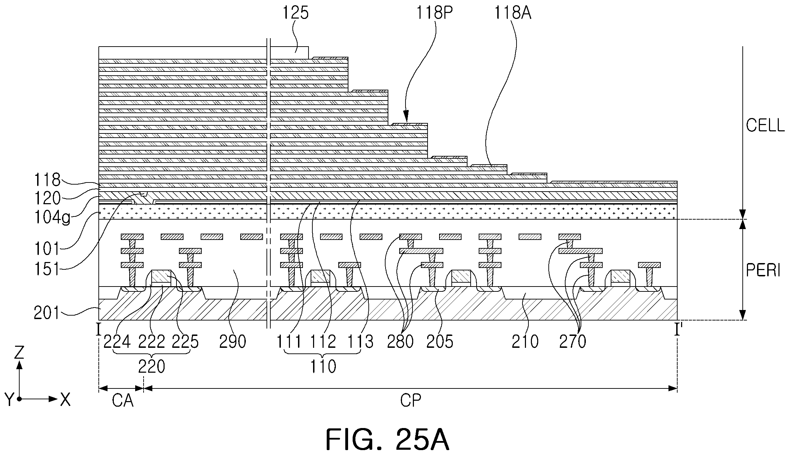

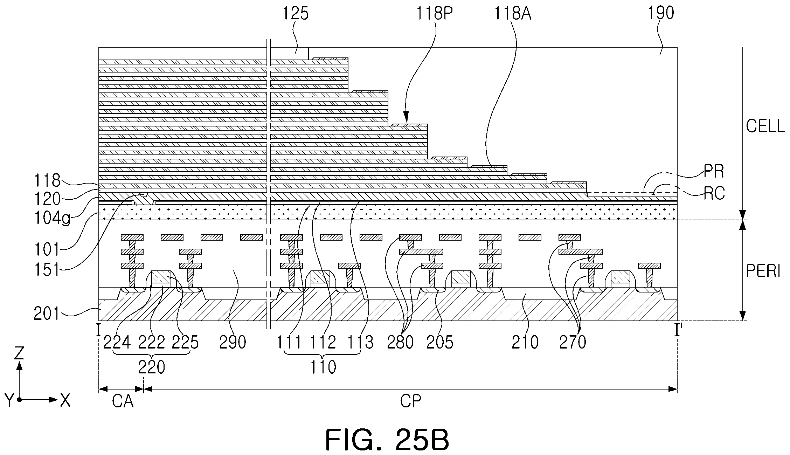

FIGS. 25A and 25B are schematic cross-sectional views illustrating a method of manufacturing a semiconductor device according to an example embodiment. Each of FIGS. 25A and 25B illustrates cross-sections corresponding to FIG. 9A.

Referring to FIG. 25A, a plate layer 101, a horizontal insulating layer 110, and a second horizontal conductive layer 104 may be formed on the peripheral circuit region PERI, the lower mold structure may be formed, and pad sacrificial layers 118A may be formed.

For the formation process of the same constituent, each process described above with reference to FIGS. 12 to 17 may be equally applied. However, in this example embodiment, similarly with the process described above with reference to FIG. 24A, the horizontal insulating layer 110 may not have an end in the cell pad region CP, and the second horizontal conductive layer 104g may also extend without being bent. Accordingly, in the process described above with reference to FIG. 15, the pad insulating layer 150 may not be formed, but only the planarizing insulating layer 151 and the substrate insulating layers 121 (see FIG. 2B) may be formed. Additionally, when forming the stepped structure described above with reference to FIG. 16, a lowermost sacrificial insulating layer 118 may not be removed and a relatively long sacrificial pad region 118P may be formed. Accordingly, the dummy sacrificial layer 118D as illustrated in FIG. 17 may not be formed.

Referring to FIG. 25B, a portion of a lowermost pad sacrificial layer 118A and a portion of a lowermost sacrificial insulating layer 118 may be removed.

After forming a mask layer covering the stepped structure of the lower mold structure and exposing a portion of a lowermost sacrificial pad region 118P, a portion of the lowermost pad sacrificial layer 118A, a portion of the lowermost sacrificial insulating layer 118, and a portion of the lowermost interlayer insulating layer 120 may be removed. Accordingly, an entire stepped structure of the lower mold structure may be formed. During the etching process, a portion of the second horizontal conductive layer 104g exposed after removing the lowermost interlayer insulating layer 120 may be removed together. Accordingly, the second horizontal conductive layer 104g may have a recessed region RC outside the lower mold structure.

The cell region insulating layer 190 may be formed to fill the recessed region RC, and a region of the cell region insulating layer 190 filling the recessed region RC may be referred to as a pad insulating region PR.

Next, the semiconductor device 100g of FIGS. 9A and 9B may be manufactured by similarly performing the processes described above with reference to FIGS. 18 to 23.

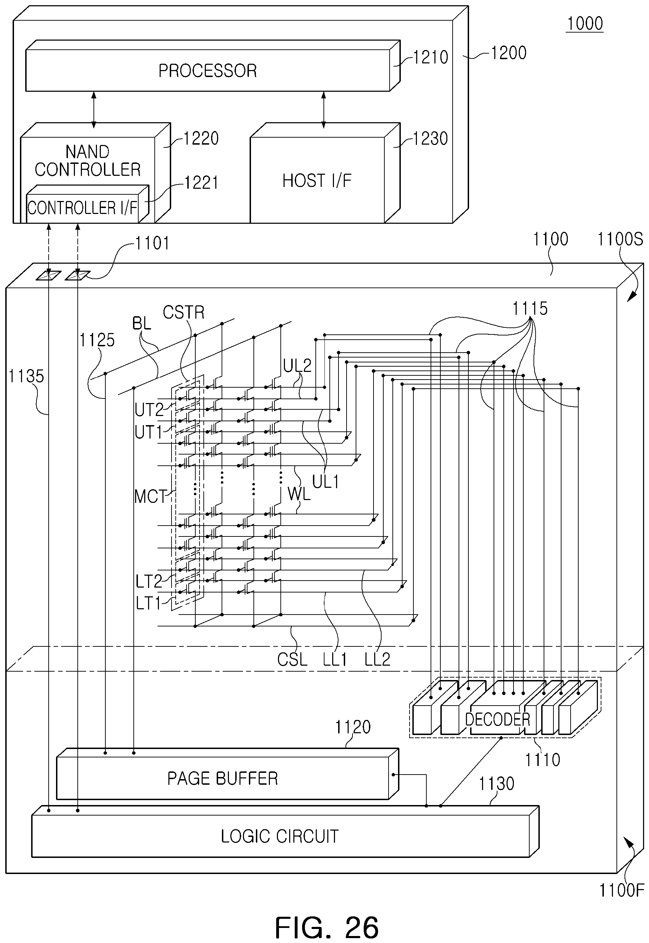

FIG. 26 is a view schematically illustrating a data storage system including a semiconductor device according to an example embodiment.

Referring to FIG. 26, a data storage system 1000 may include a semiconductor device 1100 and a controller 1200 electrically connected to the semiconductor device 1100. The data storage system 1000 may be a storage device including one or more semiconductor devices 1100, or an electronic device including the storage device. For example, the data storage system 1000 may be a solid state drive device (SSD) device, a universal serial bus (USB) device, a computing system, a medical device, or a communication device, including one or a plurality of semiconductor devices 1100.

The semiconductor device 1100 may be a non-volatile memory device, and may be, for example, a NAND flash memory device described above with reference to FIGS. 1 to 11. The semiconductor device 1100 may include a first structure 1100F and a second structure 1100S on the first structure 1100F. In some example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of memory cell string CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and upper transistors UT1 and UT2 may be variously modified according to example embodiments.

In some example embodiments, the upper transistors UT1 and UT2 may include string select transistors, and the lower transistors LT1 and LT2 may include a ground select transistor. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In some example embodiments, the lower transistors LT1 and LT2 may include a lower erase control transistor LT1 and a ground select transistor LT2 connected in series. The upper transistors UT1 and UT2 may include a string select transistor UT1 and an upper erase control transistor UT2 connected in series. At least one of the lower erase control transistor LT1 or the upper erase control transistor UT2 may be used in an erase operation of deleting data stored in memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnection lines 1115 extending from the first structure 1100F to the second structure 1100S. The bit lines BL may be electrically connected to the page buffer 1120 through second connection interconnection lines 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pad 1101 may be electrically connected to the logic circuit 1130 through an input/output connection interconnection line 1135 extending from the first structure 1100F to the second structure 1100S.

The controller 1200 may include a processor 1210, a NAND controller 1220, and a host interface 1230. According to some example embodiments, the data storage system 1000 may include a plurality of semiconductor devices 1100, and in this case, the controller 1200 may control a plurality of semiconductor devices 1100.

The processor 1210 may control an overall operation of the data storage system 1000, including the controller 1200. The processor 1210 may operate according to desired (or alternatively, predetermined) firmware, and may control the NAND controller 1220 to access the semiconductor device 1100. The NAND controller 1220 may include a controller interface 1221 that processes communication with the semiconductor device 1100. Through the controller interface 1221, control commands for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving the control commands from the external host through the host interface 1230, the processor 1210 may control the semiconductor device 1100 in response to the control commands.

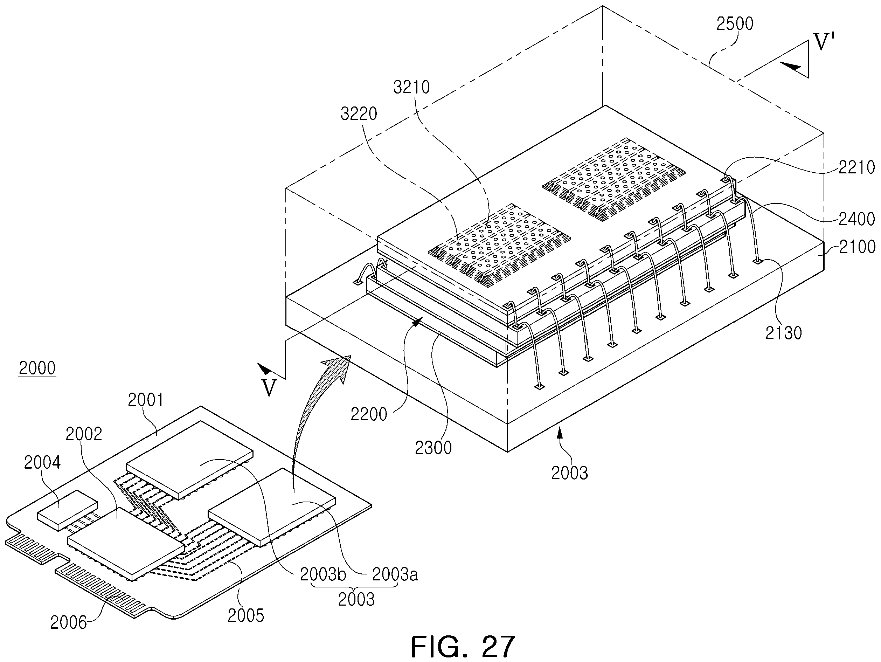

FIG. 27 is a perspective view schematically illustrating a data storage system including a semiconductor device according to an example embodiment.

Referring to FIG. 27, a data storage system 2000 according to an example embodiment of the present disclosure may include a main board 2001, a controller 2002 mounted on the main board 2001, one or more semiconductor packages 2003, and a DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to the external host. The number and arrangement of the plurality of pins in the connector 2006 may vary depending on the communication interface between the data storage system 2000 and the external host. In some example embodiments, the data storage system 2000 may communicate with the external host via any one of the following interfaces: Universal Serial Bus (USB), Peripheral Component Interconnect Express (PCI-Express), Serial Advanced Technology Attachment (SATA), and M-Phy for Universal Flash Storage (UFS). In some example embodiments, the data storage system 2000 may operate with power supplied from an external host through the connector 2006. The data storage system 2000 may further include a Power Management Integrated Circuit (PMIC) configured to distribute power supplied from the external host to the controller 2002 and the semiconductor package 2003.

The controller 2002 may record data in the semiconductor package 2003 or may read data from the semiconductor package 2003, and may improve the operating speed of data storage system 2000.

The DRAM 2004 may be a buffer memory to alleviate a speed difference between the semiconductor package 2003, a data storage space, and the external host. The DRAM 2004 included in the data storage system 2000 may also operate as a type of cache memory, and may provide a space for temporarily storing data in control operations for the semiconductor package 2003. When the data storage system 2000 includes DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 configured to electrically connect the semiconductor chips 2200 and the package substrate 2100, and a molding layer 2500 configured to cover the semiconductor chips 2200 and the connection structure 2400 on the package substrate 2100 .

The package substrate 2100 may be a printed circuit board including package upper pads 2130. Each of the semiconductor chips 2200 may include an input/output pad 2210. The input/output pad 2210 may correspond to the input/output pad 1101 of FIG. 26. Each of the semiconductor chips 2200 may include gate stack structures 3210 and channel structures 3220. Each of the semiconductor chips 2200 may include the semiconductor device described above with reference to FIGS. 1 to 11.

In some example embodiments, the connection structure 2400 may be a bonding wire configured to electrically connect the input/output pad 2210 and the package upper pads 2130. Accordingly, in each of the first and second semiconductor packages 2003a and 2003b, the semiconductor chips 2200 may be electrically connected to each other using a bonding wire method and may be electrically connected to the package upper pads 2130 of the package substrate 2100. According to some example embodiments, in each of the first and second semiconductor packages 2003a and 2003b, the semiconductor chips 2200 may be electrically connected to each other by a connection structure including a through-silicon via (TSV), instead of a bonding wire-type connection structure 2400.

In some example embodiments, the controller 2002 and the semiconductor chips 2200 may be included in one package. In an example embodiment, the controller 2002 and the semiconductor chips 2200 may be mounted on an additional interposer board different from the main board 2001, and the controller 2002 and the semiconductor chips 2200 may be connected to each other through interconnection lines formed on the interposer board.

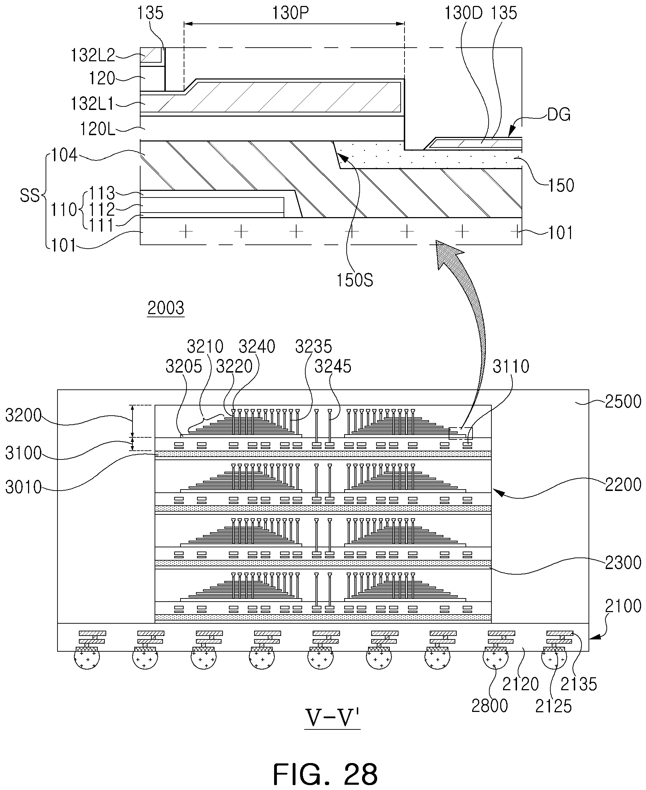

FIG. 28 is a cross-sectional view schematically illustrating a semiconductor package according to an example embodiment. FIG. 28 illustrates an example embodiment of the semiconductor package 2003 of FIG. 27 and conceptually illustrates a region in which the semiconductor package 2003 of FIG. 27 is cut along cutting line V-V'.

Referring to FIG. 28, in the semiconductor package 2003, the package substrate 2100 may be a printed circuit board. The package substrate 2100 may include a package substrate body portion 2120, package upper pads 2130 (see FIG. 27) disposed on an upper surface of the package substrate body portion 2120, lower pads 2125 disposed on or exposed through a lower surface of the package substrate body portion 2120, and internal interconnection lines 2135 electrically connecting the package upper pads 2130 and the lower pads 2125 inside the package substrate body portion 2120. The lower pads 2125 may be connected to the interconnection patterns 2005 of the main board 2001 of the data storage system 2000 as illustrated in FIG. 27 through conductive connectors 2800.

Each of the semiconductor chips 2200 may include a semiconductor substrate 3010 and a first structure 3100 and a second structure 3200 sequentially stacked on the semiconductor substrate 3010. The first structure 3100 may include a peripheral circuit region including peripheral interconnection lines 3110. The second structure 3200 may include a common source line 3205, a gate stack structure 3210 on common source line 3205, channel structures 3220 penetrating through the gate stack structure 3210, bit lines 3240 electrically connected to the channel structures 3220, and contact plugs 3235 electrically connected to the word lines WL of the gate stack structure 3210 (see FIG. 26). As described above with reference to FIGS. 1 to 11, in each of the semiconductor chips 2200, a pad insulating layer 150 or a pad insulating region may be disposed on the second horizontal conductive layer 104 outside the gate electrodes 130.

Each of the semiconductor chips 2200 may include a through-interconnection line 3245 electrically connected to the peripheral interconnection lines 3110 of the first structure 3100 and extending into the second structure 3200. The through-interconnection line 3245 may be disposed outside the gate stack structure 3210 and may be further disposed to penetrate the gate stack structure 3210. Each of the semiconductor chips 2200 may further include an input/output pad 2210 (see FIG. 27) electrically connected to the peripheral interconnection lines 3110 of the first structure 3100.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The present disclosure is not limited to the above-described example embodiments and the accompanying drawings but is defined by the appended claims. Therefore, those of ordinary skill in the art may make various replacements, modifications, changes, or combinations of the disclose example embodiments without departing from the scope of the present disclosure defined by the appended claims, and these replacements, modifications, changes, or combinations of embodiments should be construed as being included in the scope of the present disclosure.

## Claims

1. A semiconductor device, comprising:
a first semiconductor structure including a substrate, circuit elements on the substrate, and circuit interconnection lines on the circuit elements; and
a second semiconductor structure on the first semiconductor structure,
wherein the second semiconductor structure includes:
a plate layer,
gate electrodes on the plate layer, the gate electrodes spaced apart from each other in a first direction perpendicular to an upper surface of the plate layer, the gate electrodes extending by different lengths in a second direction perpendicular to the first direction, the gate electrodes each including a gate pad region, an upper surface of the gate pad region of a corresponding one of the gate electrodes being exposed upwardly from other ones of the gate electrodes,
interlayer insulating layers alternately stacked with the gate electrodes,
a horizontal insulating layer on a portion of the plate layer and below the interlayer insulating layers,
a horizontal conductive layer on the horizontal insulating layer and below the interlayer insulating layers, the horizontal conductive layer being bent and extended so that a level of an upper surface thereof is lowered from a first level to a second level,
a pad insulating layer on the horizontal conductive layer in a region in which the upper surface of the horizontal conductive layer is at the second level,
channel structures penetrating through at least a portion of the gate electrodes and extending in the first direction, and
contact plugs each connected to the gate pad region of a corresponding one of the gate electrodes and extending in the first direction.

2. The semiconductor device of claim 1, wherein the second semiconductor structure further includes a dummy structure on the pad insulating layer and the dummy structure is spaced apart from an end of a lowermost interlayer insulating layer among the interlayer insulating layers in the second direction.

3. The semiconductor device of claim 2, wherein the dummy structure includes a same material as a material of the gate electrodes.

4. The semiconductor device of claim 2 or claim 3, wherein the dummy structure is spaced apart from the horizontal conductive layer by the pad insulating layer.

5. The semiconductor device of any preceding claim, wherein a side surface in the second direction and a lower surface of the pad insulating layer are in contact with the horizontal conductive layer.

6. The semiconductor device of claim 5, wherein the side surface of the pad insulating layer is between an outermost channel structure among the channel structures in the second direction and an end of a lowermost gate electrode among the gate electrodes, in the second direction.

7. The semiconductor device of claim 5 or claim 6, wherein the side surface of the pad insulating layer is below the gate pad region of a lowermost gate electrode among the gate electrodes.

8. The semiconductor device of any preceding claim, wherein at least a portion of an upper surface of the pad insulating layer is on a level lower than the first level of the upper surface of the horizontal conductive layer.

9. The semiconductor device of any preceding claim, wherein the horizontal conductive layer covers an end of the horizontal insulating layer in the second direction, is bent to contact the plate layer, and extends onto the plate layer.

10. The semiconductor device of any preceding claim, wherein the plate layer has a step structure, and the horizontal conductive layer is bent along the step structure of the plate layer.

11. The semiconductor device of claim 10, wherein the horizontal insulating layer and the horizontal conductive layer cover an end of the plate layer in the second direction and are bent to extend onto the first semiconductor structure.

12. The semiconductor device of any preceding claim, wherein each of the gate electrodes has an increased thickness in the gate pad region thereof.

13. The semiconductor device of any preceding claim, wherein each of the contact plugs includes a vertical extension portion extending by penetrating through the gate electrodes in the first direction and a horizontal extension portion extending horizontally from the vertical extension portion and contacting one of the gate electrodes.

14. A data storage system, comprising:
the semiconductor device of any one of the preceding claims, the semiconductor device further including an input/output pad electrically connected to the circuit elements; and
a controller electrically connected to the semiconductor device through the input/output pad and configured to control the semiconductor device.
